# EUROPEAN PATENT SPECIFICATION

(11) **EP 3 607 689 B1**
(45) Date of publication and mention of the grant of the patent: **13.03.2024**
(21) Application number: 18777082.1
(22) Date of filing: 30.03.2018
(51) Int. Cl.: H03M 13/13, H03M 13/29, H03M 13/27, H04L 1/00, H03M 13/09, H04L 1/18

(54) **COMMUNICATION SYSTEM AND METHOD HAVING POLAR CODING WITH TWO CONCATENATED CYCLIC REDUNDANCY CHECK CODES**
KOMMUNIKATIONSSYSTEM UND VERFAHREN MIT POLARCODIERUNG MIT ZWEI VERKETTETEN ZYKLISCHEN REDUNDANZ-CHECKCODES
SYSTÈME ET PROCÉDÉ DE COMMUNICATION AYANT UN CODAGE POLAIRE AVEC DEUX CODES DE CONTRÔLE DE REDONDANCE CYCLIQUE CONCATÉNÉS

(30) Priority: 01.04.2017 WO PCT/CN2017/079325; 06.04.2017 WO PCT/CN2017/079526; 06.06.2017 US 201762516073 P; 14.06.2017 US 201762519756 P
(43) Date of publication of application: 12.02.2020
(73) Proprietor: QUALCOMM Incorporated, San Diego, CA 92121-1714 (US)
(72) Inventor: XU, Changlong, San Diego, California 92121-1714 (US); JIANG, Jing, San Diego, California 92121-1714 (US); YANG, Yang, San Diego, California 92121-1714 (US); SARKIS, Gabi, San Diego, California 92121-1714 (US); WEI, Chao, San Diego, California 92121-1714 (US); WU, Gaojin, San Diego, California 92121-1714 (US); LI, Jian, San Diego, California 92121-1714 (US); HOU, Jilei, San Diego, California 92121-1714 (US); LIN, Jamie Menjay, San Diego, CA 92121-1714 (US)
(74) Representative: Dunlop, Hugh Christopher
(86) International application number: PCT/CN2018/081416
(87) International publication number: WO 2018/177427

(56) References cited:
- EP-A1- 2 802 080
- EP-A1- 2 899 911
- WO-A1-2014/071658
- NTT DOCOMO: "Performance evaluation of Polar codes", 3GPP DRAFT; R1-1702849_PERFORMANCE_POLAR, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Athens, Greece; 20170213 - 20170217 12 February 2017 (2017-02-12), XP051209994, Retrieved from the Internet: URL:http://www.3gpp.org/ftp/Meetings_3GPP_ SYNC/RAN1/Docs/ [retrieved on 2017-02-12]
- ZHOU HUAYI ET AL: "Segmented CRC-Aided SC List Polar Decoding", PROC., IEEE 83RD VEHICULAR TECHNOLOGY CONFERENCE (VTC SPRING), IEEE, 15 May 2016 (2016-05-15), pages 1-5, XP032918751, DOI: 10.1109/VTCSPRING.2016.7504469 [retrieved on 2016-07-05]
- NTT DOCOMO: "CRC related design of Polar codes", 3GPP DRAFT; R1-1705756, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Spokane, USA; 20170403 - 20170407 25 March 2017 (2017-03-25), XP051252171, Retrieved from the Internet: URL:http://www.3gpp.org/ftp/tsg_ran/WG1_RL 1/TSGR1_88b/Docs/ [retrieved on 2017-03-25]

## Description

### TECHNICAL FIELD

The present disclosure relates to wireless communication systems, and more particularly to encoding and decoding information.

### INTRODUCTION

Improvements in channel coding, specifically forward error correction (FEC) codes, have contributed significantly to the development of increasingly higher data-rate communication systems, from 2G to 3G, then to 4G, and more recently to 5G, as such technologies are commonly known. Polar codes form a class of FEC codes that is proving to be advantageous. In polar coding, a representation of a physical channel is copied and transformed into N sub-channels, where the number N is the block length of the polar code. Each sub-channel has an associated reliability. That is, as N approaches infinity, each sub-channel is characterized as either increasingly noisy or decreasingly noisy. The term "reliability" relates to resistance of a channel to adverse effects of noise. Reliability is thus inversely related to noisiness. As generating a polar code enables *a priori* knowledge of the reliability of each sub-channel, the K most reliable sub-channels can be used to transmit information, while the N-K remaining sub-channels are "frozen" or set to a predetermined bit value known to both the transmitter and receiver.

A method known as successive cancellation list (SCL) decoding may be used in decoding polar codes. In SCL decoding, the number of decoding paths in a tree structure is doubled at each decoding stage, and the paths are added to a list. Each decoding stage represents a decision of either 0 or 1 at a node of the tree. A pruning method is used at each stage to discard all but the "L" most reliable or "best" paths. Performance of SCL decoding may be improved by employing concatenated coding, in which a cyclic redundancy check (CRC) code is added to the information before polar encoding. Such a concatenating coding method may be referred to as CRC-aided (CA) SCL (CA-SCL).

NTT DOCOMO: "Performance evaluation of Polar codes", 3GPP DRAFT; R1 -1702849 PERFORMANCE POLAR, 3RD GENERATION PARTNERSHIP PROJECT (3GPP), vol. RAN WG1, no. Athens, Greece; 20170213-20170217 12 February 2017 (2017-02-12), XP051209994, relates to performance evaluation of polar codes. ZHOU HUAYI ET AL: "Segmented CRC-Aided SC List Polar Decoding", 2016 IEEE 83RD VEHICULAR TECHNOLOGY CONFERENCE (VTC SPRING), IEEE, 15 May 2016 (2016-05-15), pages 1-5, XP032918751, relates to a segmented CRC-aided SCL (SCA-SCL) decoder. QUALCOMM INCORPORATED: "DL MIMO Transmission Schemes", 3GPP DRAFT; R1-166379, 3RD GENERATION PARTNERSHIP PROJECT (3GPP), FRANCE, vol. RAN WG1, no. Gothenburg, Sweden; 20160822 -20160826 21 August 2016 (2016-08-21), XP051140195, relates to CRC related design of Polar codes.

### SUMMARY

The invention is as set out in the appended claims.

### BRIEF DESCRIPTION OF THE DRAWINGS

In the figures, like reference numerals refer to like parts throughout the various views unless otherwise indicated. For reference numerals with letter character designations such as "102a" or "102b", the letter character designations may differentiate two like parts or elements present in the same figure. Letter character designations for reference numerals may be omitted when it is intended that a reference numeral encompass all parts having the same reference numeral in all figures.
FIG. 1 is a network diagram illustrating an example of a communication network architecture, in accordance with various aspects of the present disclosure.
FIG. 2 is a block diagram illustrating an example of a system comprising a transmitter and a receiver, in accordance with various aspects of the present disclosure.
FIG. 3 is a block diagram illustrating an example of a transceiver, in accordance with various aspects of the present disclosure.
FIG. 4 is a block diagram illustrating an example of two transceivers in communication with each other, in accordance with various aspects of the present disclosure.
FIG. 5 is a block diagram illustrating another example of a transceiver, in accordance with various aspects of the present disclosure.
FIG. 6 is a block diagram illustrating an example of CRC-aided polar coding, in accordance with various aspects of the present disclosure.
FIG. 7 is a block diagram illustrating an example of CRC attachment or combination, which is not in consistent with the claimed invention.
FIG. 8 is a block diagram illustrating another example of CRC attachment or combination, which is not consistent with the claimed invention.
FIG. 9 is a block diagram illustrating polar encoding using two concatenated CRC values, in accordance with various aspects of the present disclosure.
FIG. 10A is a data diagram illustrating calculation of first CRC data (CRC1) based on source data, in accordance with various aspects of the present disclosure.
FIG. 10B is a data diagram illustrating concatenation of the source data and the CRC1 of FIG. 10A.
FIG. 11 is a data diagram illustrating an example of calculation of second CRC data (CRC2) based on the source data and concatenated CRC1, and allocation of bit positions for the source data, CRC1, CRC2, and frozen bits, in accordance with various aspects of the present disclosure.
FIG. 12 is a data diagram illustrating another example of calculation of CRC2 data based on the source data and concatenated CRC1, and another example of allocation of bit positions for the source data, CRC1, CRC2, and frozen bits, which is not consistent with the claimed invention.
FIG. 13 is a block diagram illustrating an example of channel polarization, in accordance with various aspects of the present disclosure.
FIG. 14 is a block diagram illustrating an example of the encoding portion of a transmitter, in accordance with various aspects of the present disclosure.
FIG. 15 is a block diagram illustrating an example of the decoding portion of a receiver, in accordance with various aspects of the present disclosure.
FIG. 16 is a method flow diagram illustrating an example of a method for communication, in accordance with various aspects of the present disclosure.
FIG. 17 is a method flow diagram illustrating an example of a polar encoding portion of the method illustrated in FIG. 16.
FIG. 18, which is not in accordance with the claimed invention, is a method flow diagram illustrating another example of a polar encoding portion of the method illustrated in FIG. 16.
FIG. 19 is a block diagram illustrating an example of decoding, which is not consistent with the claimed invention.
FIG. 20 is a block diagram illustrating another example of decoding, which is not consistent with the claimed invention.
FIG. 21 is a method flow diagram illustrating another example of a method for communication, which is not consistent with the claimed invention.
FIG. 22 is a method flow diagram illustrating still another example of a method for communication, which is not consistent with the claimed invention.
FIG. 23 is a method flow diagram illustrating an example of using CRC2 for early pruning in the method illustrated in FIG. 22.
FIG. 24 is a method flow diagram illustrating an example of using CRC2 for early decoding termination in the method illustrated in FIG. 22.
FIG. 25 is a functional block diagram illustrating a device for communication, in accordance with various aspects of the present disclosure.
FIG. 26 is a functional block diagram illustrating another device for communication which is not consistent with the claimed invention.

### DETAILED DESCRIPTION

The word "exemplary" is used herein to mean "serving as an example, instance, or illustration." Any aspect described herein as "exemplary" is not necessarily to be construed as preferred or advantageous over other aspects.

Several aspects of telecommunication systems will now be presented with reference to various apparatus and methods. These apparatus and methods will be described in the following detailed description and illustrated in the accompanying drawings by various blocks, components, circuits, processes, algorithms, etc. (collectively referred to as "elements"). These elements may be implemented using electronic hardware, computer software, or any combination thereof. Whether such elements are implemented as hardware or software depends upon the particular application and design constraints imposed on the overall system.

By way of example, an element, or any portion of an element, or any combination of elements may be implemented as a "processing system" that includes one or more processors. Examples of processors include microprocessors, microcontrollers, graphics processing units (GPUs), central processing units (CPUs), application processors, digital signal processors (DSPs), reduced instruction set computing (RISC) processors, systems on a chip (SoC), baseband processors, field programmable gate arrays (FPGAs), programmable logic devices (PLDs), state machines, gated logic, discrete hardware circuits, and other suitable hardware configured to perform the various functionality described throughout this disclosure. One or more processors in the processing system may execute software. Software shall be construed broadly to mean instructions, instruction sets, code, code segments, program code, programs, subprograms, software components, applications, software applications, software packages, routines, subroutines, objects, executables, threads of execution, procedures, functions, etc., whether referred to as software, firmware, middleware, microcode, hardware description language, or otherwise.

Accordingly, in one or more exemplary embodiments, the functions described may be implemented in hardware, software, or any combination thereof. If implemented in software, the functions may be stored on or encoded as one or more instructions or code on a non-transitory computer-readable medium. Non-transitory computer-readable media include computer-readable storage media. Computer-readable storage media may be any available media that can be accessed by a computer or computer-based device. By way of example, and not limitation, such computer-readable storage media can comprise a random-access memory (RAM), a read-only memory (ROM), an electrically erasable programmable ROM (EEPROM), flash memory, optical disk storage, magnetic disk storage, other magnetic storage devices, combinations of the aforementioned types of computer-readable media, or any other medium that can be used to store computer executable code in the form of instructions or data structures that can be accessed by a computer or computer-based device.

The following description provides examples, and is not limiting of the scope, applicability, or examples set forth in the claims. Changes may be made in the function and arrangement of elements discussed without departing from the scope of the invention as specified in the claims. Various examples may omit, substitute, or add various procedures or components as appropriate. For instance, the methods described may be performed in an order different from that described, and various steps may be added, omitted, or combined. Also, features described with respect to some examples may be combined in other examples.

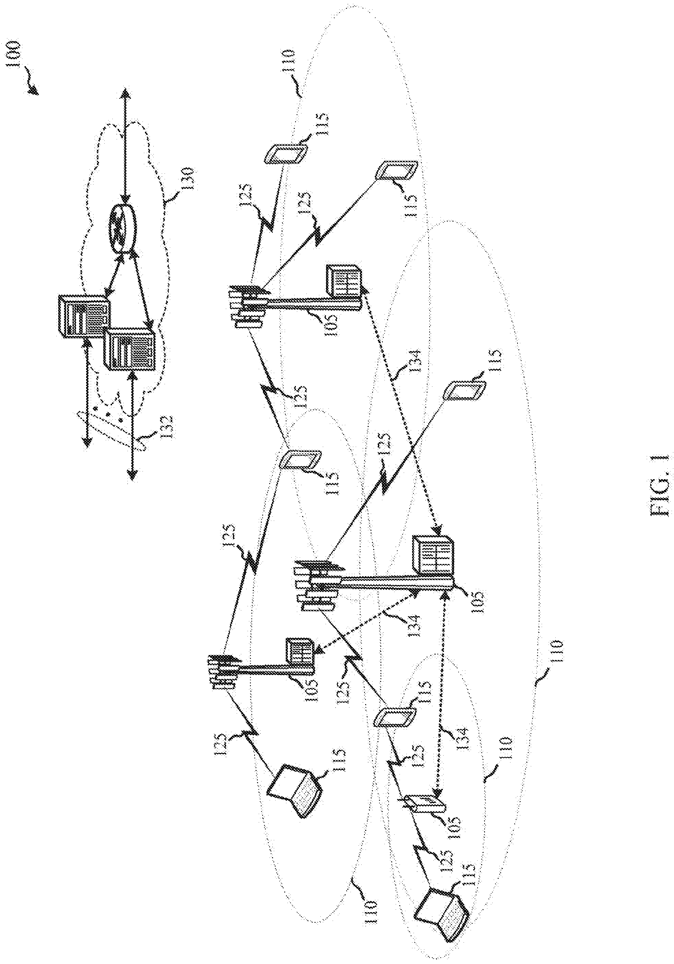

FIG. 1 illustrates an exemplary wireless communications system 100 in accordance with various aspects of the disclosure. The wireless communications system 100 includes base stations 105, UEs 115, and a core network 130. The core network 130 may provide user authentication, access authorization, tracking, Internet Protocol (IP) connectivity, and other access, routing, or mobility functions. The base stations 105 interface with the core network 130 through a first set of backhaul links 132 (e.g., S1, etc.) and may perform radio configuration and scheduling for communication with the UEs 115, or may operate under the control of a base station controller (not shown). In various examples, base stations 105 may communicate, either directly or indirectly (e.g., through core network 130), with each other over a second set of backhaul links 134 (e.g., X1, etc.), which may be wired or wireless communication links.

Each base station site may provide communication coverage for a respective geographic coverage area 110. In some examples, base stations 105 may be referred to as a base transceiver station, a radio base station, an access point, a radio transceiver, a NodeB, eNodeB (eNB), Home NodeB, a Home eNodeB, or some other suitable terminology. The geographic coverage area 110 for a base station 105 may be divided into sectors making up only a portion of the coverage area (not shown). Wireless communications system 100 may include base stations 105 of different types (e.g., macro and/or small cell base stations). There may be overlapping geographic coverage areas 110 for different technologies.

In some examples, wireless communications system 100 may be one or more of an LTE/LTE-A network and a 5G network. In LTE/LTE-A networks, the term evolved Node B (eNB), or in a 5G network, the term millimeter wave B (mWB) or gigabit Node B (gNB), may be used generally to describe base stations 105, while the term UE may be used generally to describe UEs 115. Wireless communications system 100 may be a heterogeneous LTE/LTE-A and 5G network in which different types of eNBs and/or mWBs provide coverage for various geographical regions. For example, each eNB, mWB, or base station 105 may provide communication coverage for a macro cell, a small cell, and/or other types of cell. The term "cell" is a 3GPP term that can be used to describe a base station, a carrier or component carrier associated with a base station, or a coverage area (e.g., sector, etc.) of a carrier or base station, depending on context. In some examples, wireless communications system 100 may be, or may include a millimeter wave communication network.

The term "NR" may be used herein to refer to "new radio," which is a way of referring to a radio interface that may be part of the 5G communication methodology. The term "NR" may be used interchangeably with the term "5G."

A macro cell generally covers a relatively large geographic area (e.g., several kilometers in radius) and may allow unrestricted access by UEs with service subscriptions with the network provider. A small cell is a lower-powered base station, as compared with a macro cell, that may operate in the same or different (e.g., licensed, unlicensed, etc.) frequency bands as macro cells. Small cells may include pico cells, femto cells, and micro cells according to various examples. A pico cell may cover a relatively smaller geographic area and may allow unrestricted access by UEs with service subscriptions with the network provider. A femto cell also may cover a relatively small geographic area (e.g., a home) and may provide restricted access by UEs having an association with the femto cell (e.g., UEs in a closed subscriber group (CSG), UEs for users in the home, and the like). An eNB for a macro cell may be referred to as a macro eNB. An eNB for a small cell may be referred to as a small cell eNB, a pico eNB, a femto eNB or a home eNB. An eNB may support one or multiple (e.g., two, three, four, and the like) cells (e.g., component carriers).

Wireless communications system 100 may support synchronous or asynchronous operation. For synchronous operation, base stations 105 may have similar frame timing, and transmissions from different base stations may be approximately aligned in time. For asynchronous operation, base stations 105 may have different frame timing, and transmissions from different base stations may not be aligned in time.

The communication networks that may accommodate some of the various disclosed examples may be packet-based networks that operate according to a layered protocol stack. In the user plane, communications at the bearer or Packet Data Convergence Protocol (PDCP) layer may be IP-based. A Radio Link Control (RLC) layer may perform packet segmentation and reassembly to communicate over logical channels. A Medium Access Control (MAC) layer may perform priority handling and multiplexing of logical channels into transport channels. The MAC layer may also use Hybrid ARQ (HARQ) to provide retransmission at the MAC layer to improve link efficiency. In the control plane, the Radio Resource Control (RRC) protocol layer may provide establishment, configuration, and maintenance of an RRC connection between a UE 115 and the base stations 105 or core network 130 supporting radio bearers for the user plane data. At the Physical (PHY) layer, the transport channels may be mapped to Physical channels.

The UEs 115 are dispersed throughout the wireless communications system 100, and each UE 115 may be stationary or mobile. A UE 115 may also include or be referred to by those skilled in the art as a mobile station, a subscriber station, a mobile unit, a subscriber unit, a wireless unit, a remote unit, a mobile device, a wireless device, a wireless communications device, a remote device, a mobile subscriber station, an access terminal, a mobile terminal, a wireless terminal, a remote terminal, a handset, a user agent, a mobile client, a client, or some other suitable terminology. A UE 115 may be a cellular phone, a personal digital assistant (PDA), a wireless modem, a wireless communication device, a handheld device, a tablet computer, a laptop computer, a cordless phone, a wireless local loop (WLL) station, or the like. A UE 115 may be able to communicate with various types of base stations and network equipment including macro eNBs, small cell eNBs, mWBs, relay base stations, and the like. A UE 115 may also be able to communicate with other UEs either within or outside the same coverage area of a base station via D2D communications.

The communication links 125 shown in wireless communications system 100 may carry or represent uplink (DL) transmissions from a UE 115 to a base station 105, and/or downlink (DL) transmissions from a base station 105 to a UE 115. The downlink transmissions may also be called forward link transmissions while the uplink transmissions may also be called reverse link transmissions. Each communication link 125 may include one or more carriers, where each carrier may be a signal made up of multiple sub-carriers (e.g., waveform signals of different frequencies) modulated according to the various radio technologies described above. Each modulated signal may be sent on a different sub-carrier and may carry control information (e.g., reference signals, control channels, etc.), overhead information, user data, etc. The communication links 125 may transmit bidirectional communications using FDD (e.g., using paired spectrum resources) or TDD operation (e.g., using unpaired spectrum resources). Frame structures for FDD (e.g., frame structure type 1) and TDD (e.g., frame structure type 2) may be defined.

In some examples, base stations 105 and/or UEs 115 may include multiple antennas for employing antenna diversity schemes to improve communication quality and reliability between base stations 105 and UEs 115. Additionally or alternatively, base stations 105 and/or UEs 115 may employ multiple-input, multiple-output (MIMO) techniques that may take advantage of multi-path environments to transmit multiple spatial layers carrying the same or different coded data.

The modulation and multiple access scheme employed by UEs 115 and base stations 105 may vary depending on the particular telecommunications standard being deployed. In LTE applications, OFDM is used on the DL and SC-FDMA is used on the UL to support both frequency division duplex (FDD) and time division duplex (TDD). As those skilled in the art will readily appreciate from the detailed description to follow, the various concepts presented herein are well suited for LTE applications. However, these concepts may be readily extended to other telecommunication standards employing other modulation and multiple access techniques. By way of example, these concepts may be extended to Evolution-Data Optimized (EV-DO), Ultra Mobile Broadband (UMB), 5G, or other modulation and multiple access techniques. EV-DO and UMB are air interface standards promulgated by the 3rd Generation Partnership Project 2 (3GPP2) as part of the CDMA2000 family of standards and employs CDMA to provide broadband Internet access to mobile stations. These concepts may also be extended to Universal Terrestrial Radio Access (UTRA) employing Wideband-CDMA (W-CDMA) and other variants of CDMA, such as TD-SCDMA; Global System for Mobile Communications (GSM) employing TDMA; and Evolved UTRA (E-UTRA), IEEE 802.11 (Wi-Fi), IEEE 802.16 (WiMAX), IEEE 802.20, and Flash-OFDM employing OFDMA. UTRA, E-UTRA, UMTS, LTE and GSM are described in documents from the 3GPP organization. CDMA2000 and UMB are described in documents from the 3GPP2 organization. The actual wireless communication standard and the multiple access technology employed will depend on the specific application and the overall design constraints imposed on the system.

Coding methods set forth in this disclosure may be employed in association with transmitting or receiving communications such as, for example, control channel communications. Control channels may include channels through which a UE 115 may transmit uplink transmissions to a base station 105, such as, for example, a physical uplink control channel (PUCCH). As known to one of ordinary skill in the art, the PUCCH may be used for HARQ signaling, MIMO feedback, scheduling requests for uplink transmissions, or other tasks. Control channels may also include channels through which a base station 105 may transmit downlink transmissions to a UE 115, such as, for example, a physical downlink control channel (PDCCH). As known to one of ordinary skill in the art, the PDCCH may be used for HARQ signaling, to inform the UE 115 about resource allocations of various channels, or other tasks. Control channel communications serve only as an example of a type or class of communications in association with which coding methods set forth in this disclosure may be employed, and others will readily occur to one of ordinary skill in the art in view of this disclosure.

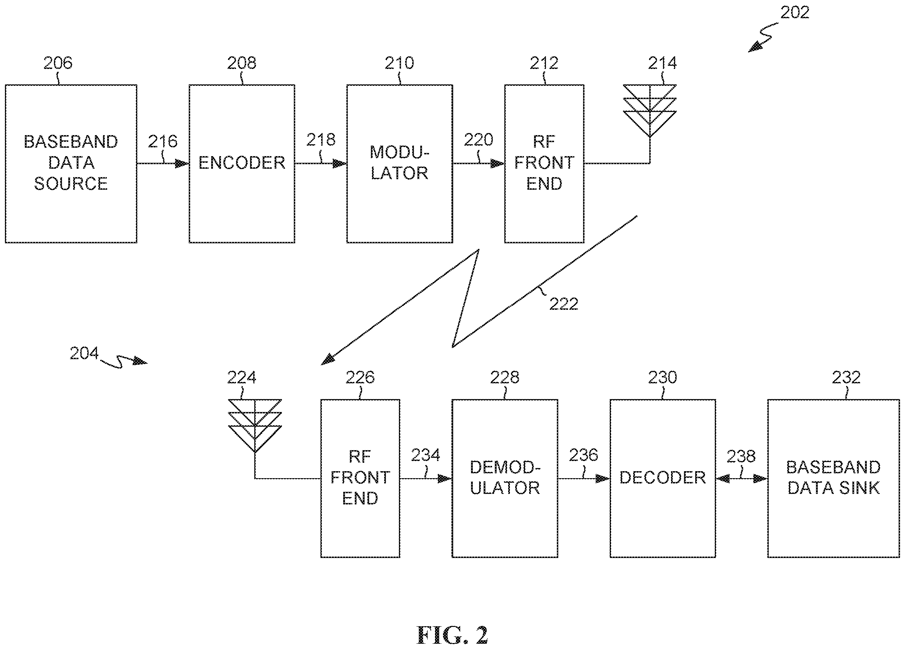

FIG. 2 is a block diagram of transmitter portion 202 and a receiver portion 204 of an exemplary communication system. Transmitter portion 202 may be an example of a transmitter portion of any of base stations 105 or UEs 115 (FIG. 1). Similarly, receiver portion 204 may be an example of a receiver portion of any of base stations 105 or UEs 115.

Transmitter portion 202 may include a baseband data source 206, an encoder 208, a modulator 210, a radio frequency (RF) front end 212, and an antenna system 214. Baseband data source 206 provides information or source data 216 for transmission. Such source data 216 may represent voice or other audio, still or video images, text, control signals, or other information to be transmitted.

Encoder 208 encodes source data 216 using polar coding in a manner described below. Polar codes are the first provably capacity-achieving coding scheme with almost linear (in block length) encoding and decoding complexity. Polar codes have many desirable properties such as deterministic construction (e.g., based on a fast Hadamard transform), low and predictable error floors, and simple successive-cancellation list (SCL) based decoding. For these reasons and others, polar codes are widely considered as a candidate for error correction in next-generation wireless communication systems.

Encoder 208 outputs polar codes, also referred to herein as polar-encoded data 218. Modulator 210 modulates polar-encoded data 218. RF front end 212 upconverts the modulated signal 220 provided by modulator 210 to radio frequencies and provides such RF signals to antenna system 214. The RF signals may be transmitted through antenna system 214 via a communication channel 222.

Receiver portion 204 includes another antenna system 224, which may receive the transmitted RF signals via channel 222. Receiver portion 204 may also include an RF front end 226, a demodulator 228, a decoder 230, and a baseband data sink 232. RF front end 226 may downconvert the received RF signals to baseband frequency signals 234. Demodulator 228 may demodulate baseband frequency signals 234. Demodulator 228 provides the resulting demodulated input data 236 to decoder 230.

Decoder 230 decodes input data 236 (i.e., polar codes) using polar decoding in a manner described below. The polar decoding includes SCL decoding or CRC-aided (CA) SCL decoding. Decoder 230 outputs decoded data 238, which baseband data sink 232 may further process in a conventional manner. Except as set forth in this disclosure, the foregoing elements of transmitter portion 202 and receiver portion 204 may have conventional structures and functions. Accordingly, such structures and functions are not described in this disclosure. Also, it should be understood that although only a single signal flow path through transmitter portion 202 and receiver portion 204 is shown in FIG. 2 for purposes of clarity, there may be multiple signal flow paths. For example, although only a single encoder 208 is shown and a single decoder 230 is shown, there may be multiple instances of such encoders and decoders.

In addition, or alternatively, a single encoder 208 or a single decoder 230 may have multiple portions or otherwise be configured to encode and decode multiple signal paths or channels, respectively. For example, one such encoder and decoder pair or portions thereof may be configured to encode and decode user data (e.g., voice or other audio, still or video images, text, etc.) while another encoder and decoder pair or portions thereof may be configured to encode and decode control signals, such as, for example, the above-described uplink and downlink control channels.

Also, although in the exemplary embodiment illustrated in FIG. 2 transmitter portion 202 and receiver portion 204 may communicate with each other via communication channel 222, in other embodiments such a transmitter portion and receiver portion may be integrated together as a transceiver. For example, each of UEs 115 or each of base stations 105 (FIG. 1) may include transmitter portion 202 and receiver portion 204.

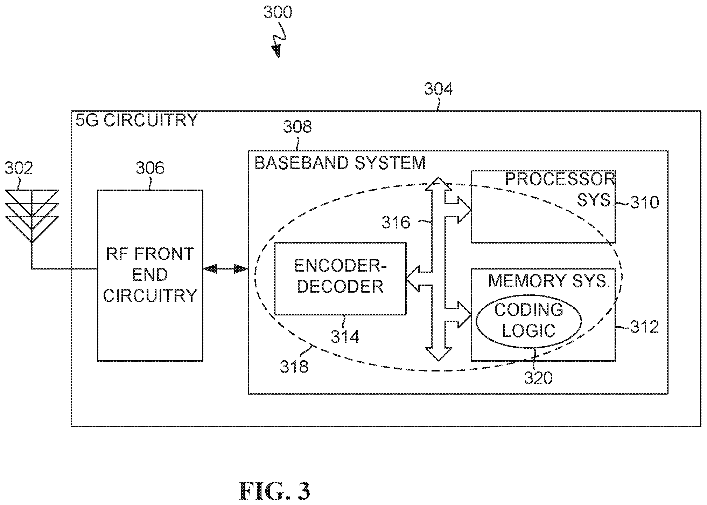

FIG. 3 is a block diagram of an exemplary UE 300, in accordance with various aspects of the present disclosure. The UE 300 may be an example of one or more aspects of UE 115 (FIG. 1) or an example of one or more aspects of transmitter portion 202 and receiver portion 204 (FIG. 2). The UE 300 may include one or more antennas 302 and 5G circuitry 304. The 5G circuitry 304 may include RF front end circuitry 306 and baseband system circuitry 308. Baseband system circuitry 308 may include a processor system 310, a memory system 312, and encoder-decoder components 314, each of which may communicate, directly or indirectly, with each other (e.g., via one or more buses 316). A channel coding system 318 may include some or all of encoder-decoder components 314, processor system 310, and memory system 312. As described in further detail below, under control of processor system 310, channel coding system 318 is configured to encode source data for transmission via RF front end circuitry 306 and antennas 302, and decode input data received via antennas 302. and RF front end circuitry 306. A portion of such encoding and decoding or other channel coding functionality may be performed under the control of processor system 310 through the execution of logic or instructions in the form of software, firmware, etc. In addition, some or all of the coding and related communication methods described in this disclosure may be performed under the control of processor system 310 through the execution of coding logic 320. In the example shown in FIG. 3, memory system 310 is configured with, among other things, coding logic 320. In this example, coding logic 320 may be in the form of software or firmware. More generally, memory system 312 or other memory (not shown) may be configured with software or firmware, which, when executed by processor system 310 or other processors (not shown), causes UE 300 to control various methods, including the methods described in this disclosure.

Although for purposes of clarity coding logic 320 is shown in FIG. 3 in a conceptual manner as stored in or residing in memory system 312 in the manner of software or firmware, it should be understood that coding logic 320 may be made accessible to processor system 310 in any manner. In addition to coding logic 320, additional logic, including logic that causes UE 300 to control conventional methods commonly associated with UE communications or other UE operation, may be included but is not shown in FIG. 3 for purposes of clarity. Also, it should be noted that memory system 312 is an example of a computer program product comprising a non-transitory computer-readable medium having instructions (e.g., coding logic 320) stored therein in computer-executable form, which, when executed by processor system 310, may effect the methods of operation described in this disclosure.

Some or all of baseband system 308 and RF front end circuitry 306 may be implemented using one or more application-specific integrated circuits (ASICs) adapted to control some or all of the associated methods or functions described herein. Alternatively, the methods or functions may be controlled by one or more other processing units (or cores), on one or more integrated circuits. In other examples, other types of integrated circuits may be used (e.g., Structured/Platform ASICs, Field Programmable Gate Arrays (FPGAs), and other Semi-Custom ICs), which may be programmed in any manner known in the art.

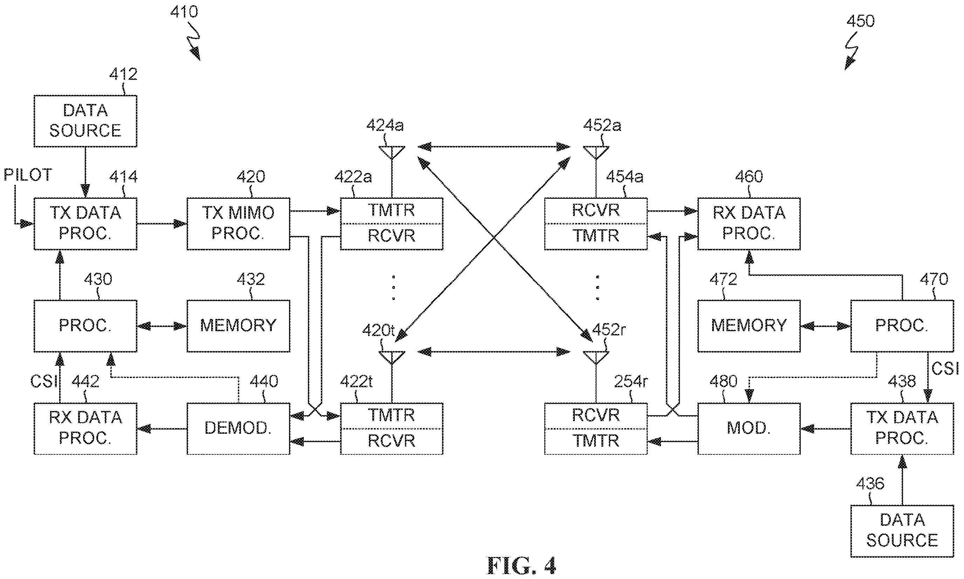

FIG. 4 illustrates an exemplary wireless communication system that may operate in accordance with MIMO principles. The system may include a base station 410 and a UE 450. Base station 410 and UE 450 may be examples of any of base stations 105 and UEs 115 (FIG. 1), respectively.

At base station 410, traffic data for a number of data streams is provided from a data source 412 to a transmit (TX) data processor 414. In one aspect of the present disclosure, each of a plurality of data streams may be transmitted over a respective transmit antenna. TX data processor 414 formats, codes, and interleaves the traffic data for each data stream based on a particular coding scheme selected for that data stream to provide coded data.

The coded data for each data stream may be multiplexed with pilot data using OFDM techniques. The pilot data is typically a known data pattern that is processed in a known manner and may be used at UE 450 to estimate the channel response. The multiplexed pilot and coded data for each data stream is then modulated (i.e., symbol mapped) based on a particular modulation scheme (e.g., BPSK, QPSK, m-QPSK, or m-QAM) selected for that data stream to provide modulation symbols. The data rate, coding, and modulation for each data stream may be determined by instructions executed by a processor 430 in association with a memory 432.

The modulation symbols for all data streams are then provided to a TX MIMO processor 420, which may further process the modulation symbols (e.g., for OFDM). TX MIMO processor 420 then provides NT modulation symbol streams to NT transmitters (TMTR) 422a through 422t. In certain aspects of the present disclosure, TX MIMO processor 420 applies beamforming weights to the symbols of the data streams and to the antenna from which the symbol is being transmitted.

Each of transmitters 422a through 422t receives and processes a respective symbol stream to provide one or more analog signals, and further conditions (e.g., amplifies, filters, and upconverts) the analog signals to provide a modulated signal suitable for transmission over the MIMO channel. NT modulated signals from transmitters 422a through 422t are then transmitted from NT antennas 424a through 424t, respectively.

At UE 450, the transmitted modulated signals may be received by NR antennas 452a through 452r. The received signal from each of antennas 452a through 452r may be provided to a respective receiver (RCVR) 454a through 454r. Each of receivers 454a through 454r may condition (e.g., filters, amplifies, and downconverts) a respective received signal, digitize the conditioned signal to provide samples, and further process the samples to provide a corresponding "received" symbol stream.

An RX data processor 460 then receives and processes the NR received symbol streams from NR receivers 454a through 454r based on a particular receiver processing technique to provide NT "detected" symbol streams. The RX data processor 460 then demodulates, deinterleaves, and decodes each detected symbol stream to recover the traffic data for the data stream. The processing by RX data processor 460 may be complementary to that performed by TX MIMO processor 420 and TX data processor 414 at base station 410.

A processor 470 periodically determines which pre-coding matrix to use. Processor 470, executing instructions in association with a memory 472, may formulate a reverse link message comprising a matrix index portion and a rank value portion. The reverse link message may comprise various types of information regarding the communication link and/or the received data stream. The reverse link message is then processed by a TX data processor 438, which also receives traffic data for a number of data streams from a data source 436. The reverse link message is modulated by a modulator 480, conditioned by transmitters 454a through 454r, and transmitted back to base station 410.

At base station 410, the modulated signals from UE 450 are received by antennas 424a through 424t, conditioned by receivers 422a through 422t, demodulated by a demodulator 440, and processed by a RX data processor 442 to extract the reserve link message transmitted by the UE 450. Processor 430 then determines which pre-coding matrix to use for determining the beamforming weights, and then processes the extracted message.

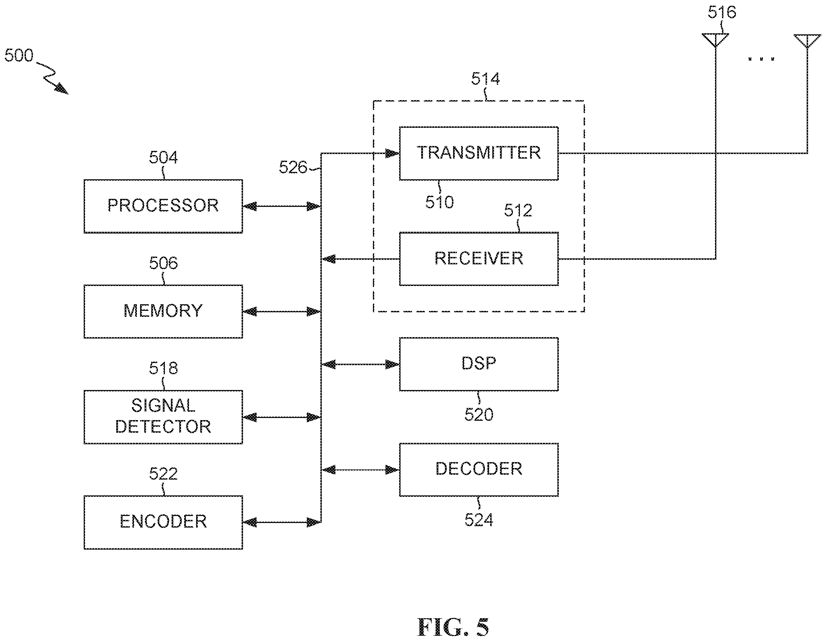

FIG. 5 illustrates an exemplary wireless device 500 that may be employed, for example, in the wireless communication system of FIG. 1. The wireless device 500 may be either a UE or a base station. For example, features of wireless device 500 may be provided in a UE in combination with UE-related features described above with regard to FIGs. 2-4. The wireless device 500 may be configured to implement the various methods described herein.

The wireless device 500 may include a processor 504 which controls operation of the wireless device 500. Processor 504 may also be referred to as a central processing unit (CPU). Memory 506, which may include both read-only memory (ROM) and random access memory (RAM), provides instructions and data to processor 304. A portion of memory 506 may also include non-volatile random access memory (NVRAM). The processor 504 typically performs logical and arithmetic operations based on program instructions stored within memory 506. The instructions in the memory 506 may be executable to implement the methods described herein.

Wireless device 500 may also include a transmitter 510 and a receiver 512 to allow transmission and reception of data between wireless device 500 and a remote location. Transmitter 510 and receiver 512 may be in a combined form of a transceiver 514. A plurality of transmit antennas 516 may be electrically coupled to the transceiver 514. Wireless device 500 may also include (not shown) multiple transmitters, multiple receivers, and multiple transceivers.

Wireless device 500 may also include a signal detector 518 that may be used in an effort to detect and quantify the level of signals received by transceiver 514. Signal detector 518 may detect such signals as total energy, energy per subcarrier per symbol, power spectral density and other signals. Wireless device 500 may also include a digital signal processor (DSP) 520 for use in processing signals.

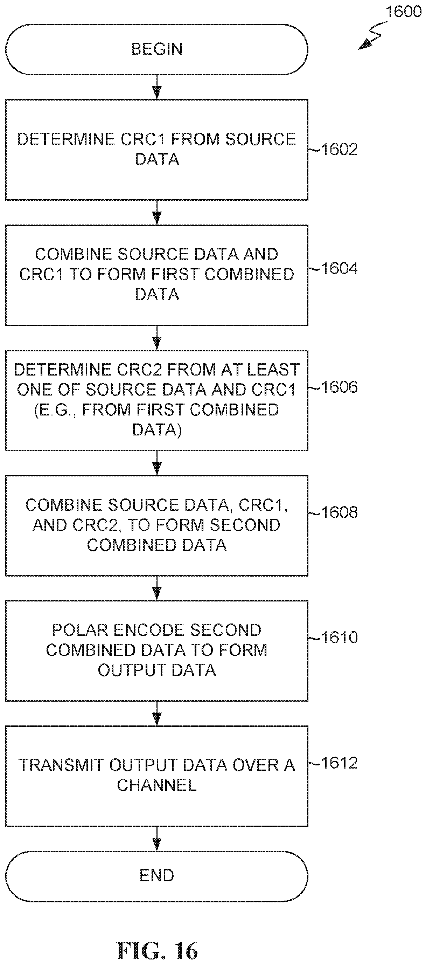

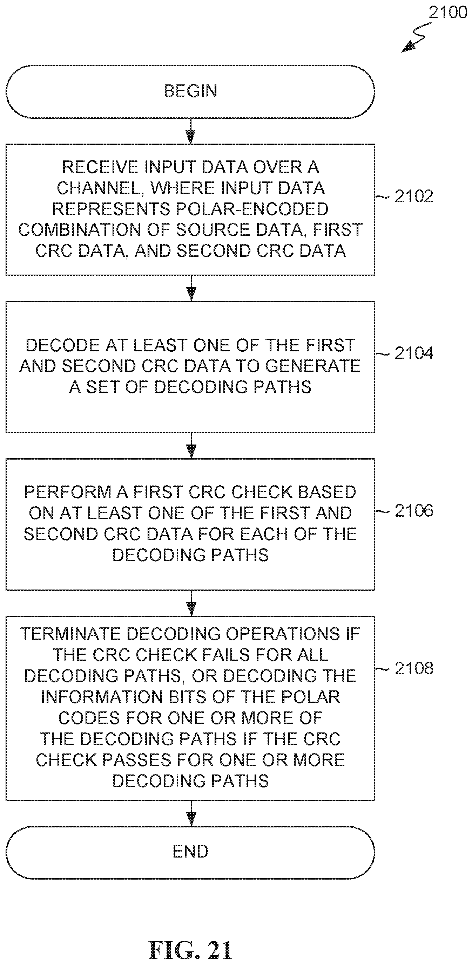

Additionally, wireless device 500 may also include an encoder 522 for use in encoding signals for transmission and a decoder 524 for use in decoding received signals. For example, encoder 522 may be configured to implement encoding methods and techniques described herein, including but not limited to the methods described below with regard to FIGs. 16-18. Decoder 524 may be configured to implement decoding methods and techniques described herein, including but not limited to the methods described below with regard to FIGs. 21-24.

The various components of wireless device 500 may be coupled together by a bus system 526, which may include a power bus, a control signal bus, and a status signal bus in addition to a data bus. Processor 504 may be configured to access instructions stored in memory 506 to perform connectionless access, in accordance with aspects of the present disclosure discussed below.

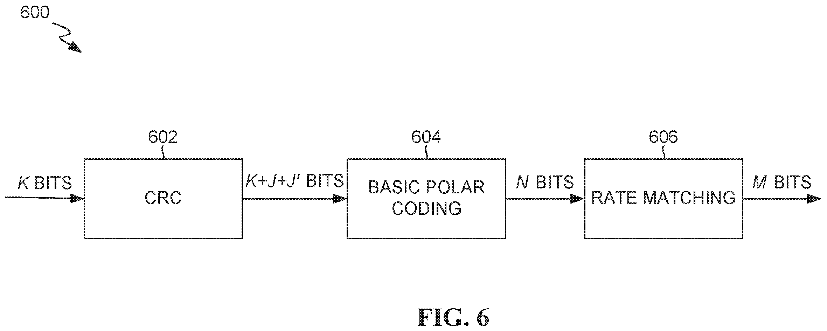

FIG. 6 illustrates an exemplary system 600 for CA-CRC polar coding, in accordance with certain aspects of the present disclosure. As illustrated, K information bits (i.e., source data) are firstly appended by CRC (block 602) to form a sequence with K+J+J' bits, where the CRC sequence (J+J') is generated based on the K information bits and used for checking the integrity of the K information bits. K' = K+J+J' bits are used as the information input corresponding to the K' "best" indices of the basic polar coding operation (block 604). The N-bit polar codes may be rate matched (block 606) before transmitting. The M-bit rate-matched polar codes may be transmitted over a channel to a receiver. When decoding at the receiver, the CRC bits may be used for both error detection and error correction. Therefore, a longer CRC (e.g., J+J' = 19 for list size of 8 and target FAR of 10-5) may be used to reduce the FAR caused by list decoding of polar codes.

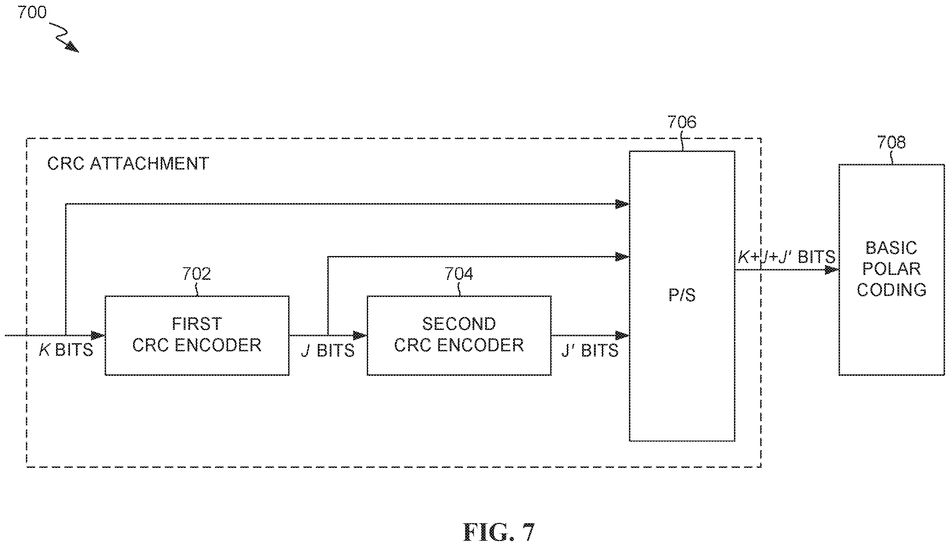

FIG. 7 illustrates an exemplary system 700 for CRC attachment or combination, which is not consistent with the claimed invention. As illustrated, K information bits (i.e., source data) are received by a first CRC encoder 702 that generates first CRC bits J (i.e. CRC1). The J CRC bits are provided to a second CRC encoder 704 that generates second CRC bits J' (i.e., CRC2) based on the CRC bits J. The K information bits, first CRC bits J, and second CRC bits J' are then concatenated using a parallel-to-serial (P/S) converter 706 to generate K+J+J' bits, based on which polar codes are generated using a polar code generator 708 and assigning J+J' CRC bits with lower indices as compared to K information bits.

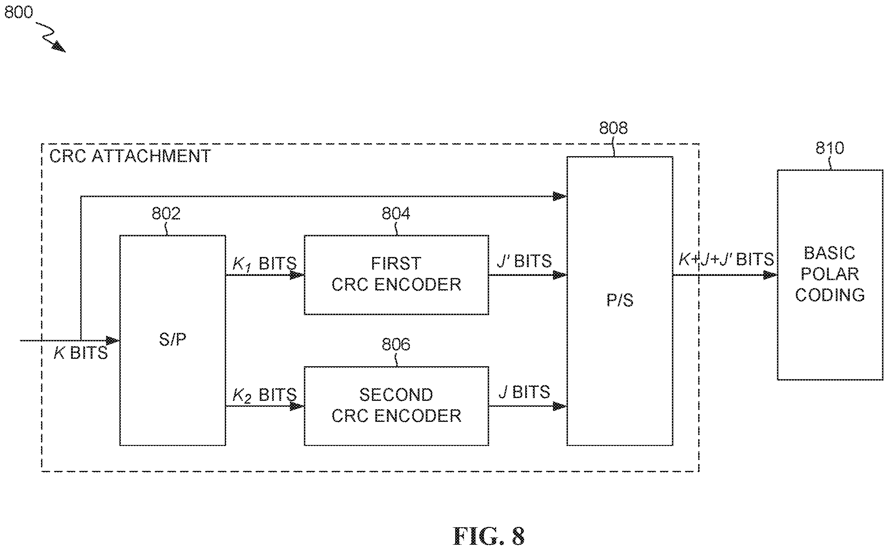

FIG. 8 illustrates an exemplary system 800 for CRC attachment or combination, which is not consistent with the claimed invention. In this case, the K information bits (i.e., source data) are split into first and second subsets of information bits K1 and K2 by a serial-to-parallel (S/P) converter 802. The information bits K1 are provided to a first CRC encoder 804, based on which CRC bits J' are generated, and the information bits K2 are provided to a second CRC encoder 806 based on which CRC bits J are generated. The K information bits, first CRC bits J, and second CRC bits J' are then concatenated using a P/S converter 808 to generate K+J+J' bits, based on which polar codes are generated using a polar code generator 810. For the decoding operations, the K1 information bits and the J' CRC bits may be decoded first to generate a plurality of decoding paths, each of which may CRC checked based on the J' CRC bits. For example, the K1 information bits and the J' CRC bits may be assigned lower indices as compared to the K2 bits and the J CRC bits. If all the decoding paths fail the CRC check, the decoding operations are terminated. Otherwise, decoding will continue with the paths that passed the CRC check. For example, the K2 information bits and the J CRC bits may be decoded to generate another plurality of decoding paths which are CRC checked based on the J CRC bits to select a final path.

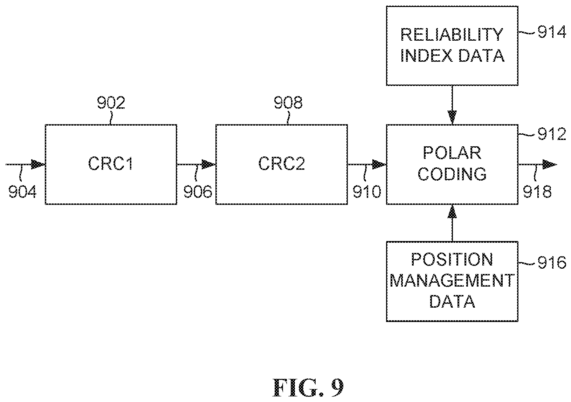

FIG. 9 illustrates an exemplary system relating to: calculating or otherwise determining first cyclic redundancy check data (CRC1) 902 from source data 904; concatenating or otherwise combining or attaching source data 904 and CRC1 902 to form first combined data 906; determining second cyclic redundancy check data (CRC2) 908 from at least one of CRC1 and the first combined data 906; combining source data 904, CRC1 902, and CRC2 908 to form second combined data 910; and applying polar coding 912 to second combined data 910 to form output data 418. In some systems and methods, the polar coding 912 may use reliability index data 914 and position management data 916.

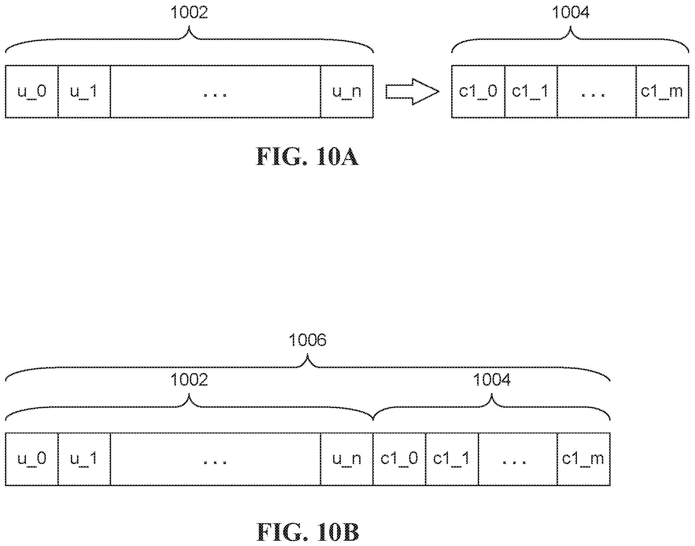

FIGs. 10A-10B illustrate information bits or source data 1002, which may be an example of source data 206 (FIG. 2) or source data 904 (FIG. 9). Source data 1002 comprises multiple information bits u_0 through u_n, with bits between the first bit u_0 and last bit u_n that are not shown for purposes of clarity being indicated by an ellipsis ("...") symbol. Source data may consist of any integer number (n+1) of bits. CRC1 1004 may be calculated or otherwise determined from source data 1002 in a conventional manner, as well understood by one of ordinary skill in the art. CRC1 1004 comprises multiple bits c1_0 through c1_m, with bits between the first bit cl_0 and last bit c1_m that are not shown for purposes of clarity being indicated by an ellipsis ("...") symbol. CRC1 1004 may consist of any integer number (m+1) of bits. As illustrated in FIG. 10B, CRC1 1004 is concatenated to or otherwise attached to or combined with source data 1002 to form first combined data 1006.

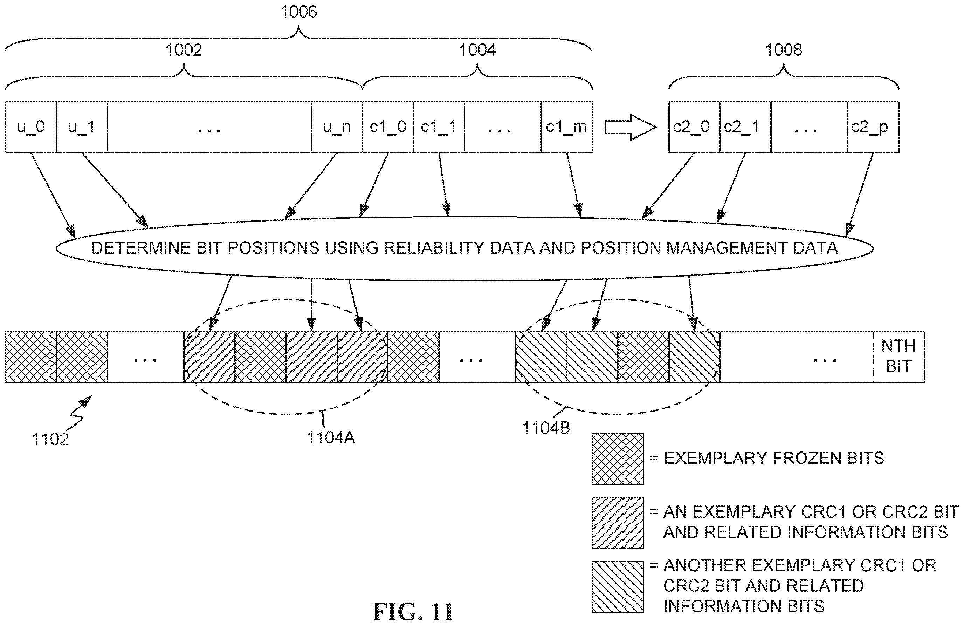

FIG. 11 illustrates calculating or otherwise determining second CRC data (CRC2) 1008 from the first combined data 1006. CRC2 1008 may be calculated or otherwise determined in a conventional manner, as well understood by one of ordinary skill in the art. CRC2. 1008 comprises multiple bits c2_0 through c2_p, with bits between the first bit c2_0 and last bit c2_p that are not shown for purposes of clarity being indicated by an ellipsis ("...") symbol. CRC2 1008 may consist of any integer number (p+1) of bits. Bit positions may then be allocated in an output data structure 1 102 for the information bits or source data 1002, the CRC bits (i.e., bits of CRC1 and CRC2), and frozen bits.

Output data structure 1102 may be a linear array having N bit positions, i.e., ranging from a first bit position to a last or Nth bit position in decoding order. Frozen bit positions may be allocated in a conventional manner. As well understood by one of ordinary skill in the art, polar encoding determines the frozen bit positions. The remaining bit positions of output data structure 1102 may be referred to as non-frozen bit positions. Referring briefly again to FIG. 9, reliability index data 914 may identify the frozen bit positions. Reliability index data 914 may be determined using a polar code generator (not shown) before the communication methods set forth in this disclosure are performed, and embodied in a data file (e.g., included in coding logic 320 (FIG. 3) or other data storage structure), thereby simplifying the remaining steps of polar coding that occur during communication. Reliability index data 914 may relate each bit position to reliability of a corresponding sub-channel. The information bit positions for source data 1002 and CRC bit positions for CRC1 1004 and CRC2 1008 may be allocated to the K most reliable bit positions, i.e., the non-frozen bit positions, in output data structure 1102. Frozen bit positions are allocated to the remaining N-K bit positions in output data structure 1102. Frozen bit positions in output data structure 1102 are set to a predetermined value, such as 0 or 1, in accordance with conventional polar encoding methods. Among the K non-frozen bit positions, information bit positions for source data 1002 and CRC bit positions for CRC1 1004 and CRC2 1008 are allocated in output data structure 1102 using position management data 916 (FIG. 9). Position management data 916 positions bits of CRC2 1008 with related information bits in positions that enable corresponding parity checking for them to be performed as early as possible.

FIG. 11 illustrates an allocation example, in which information bit positions for source data 1002 and CRC bit positions for CRC1 1004 and CRC2 1008 are allocated by using position management data 916 (FIG. 9) to identify at least one cluster 1104A, 104B, etc., of non-frozen bit positions within output data structure 1102. In such a cluster 1104A, 1104B, etc., the bit positions are sorted in decoding order. That is, the CRC2 bits are as close as possible to corresponding information bits and CRC1 bits that the CRC2 bits encode. Clustering information bit positions for source data 1002 and CRC bit positions for CRC1 1004 and CRC2 1008 in this manner provides advantages such as facilitating a bit-by-bit CRC parity check during decoding as early in the decoding process as possible. In contrast, in conventional CA-SCL decoding, CRC checking is always performed after all information bits are completely decoded. Early parity checking, as described in this disclosure, can improve decoding performance by enabling early pruning of a candidate path. Alternatively, the early parity checking can enable early decoding termination to save power. After allocating information bit positions, the information bits or source data 1002 may be copied into the correspondingly allocated bit positions in output data structure 1102. Similarly, after allocating CRC bit positions, the bits of CRC1 1004 and CRC2 1008 may be copied into the correspondingly allocated bit positions in output data structure 1102. The resulting bits as stored in output data structure 1102 define a codeword. The codeword may be further processed and transmitted in, for example, the manner described above with regard to FIG. 2 or 4. Position management data 916 may be embodied in a data file (e.g., included in coding logic 320 (FIG. 3) or other data storage structure.

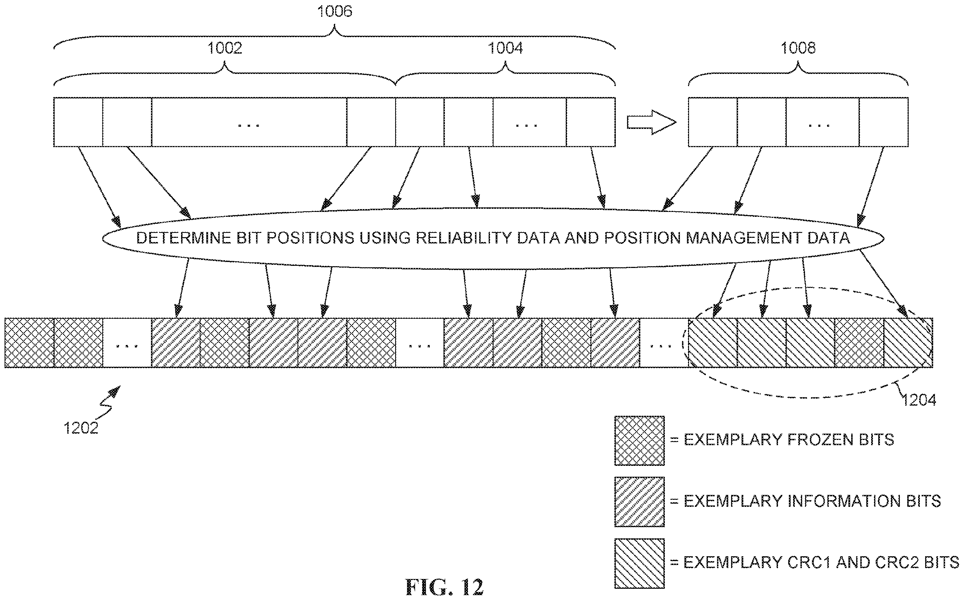

FIG. 12 illustrates another allocation example, which is not consistent with the claimed invention, in which CRC bit positions for CRC1 1004 and CRC2 1008 are allocated by using position management data 916 (FIG. 9) to identify a cluster 1204 of non-frozen bit positions at a tail of an output data structure 1202. That is, all bits of CRC1 1004 and CRC2 1008 are allocated to non-frozen bit positions nearest the Nth bit position. In this example, information bit positions for source data 1002 may be allocated to any other non-frozen bit positions in output data structure 1202.

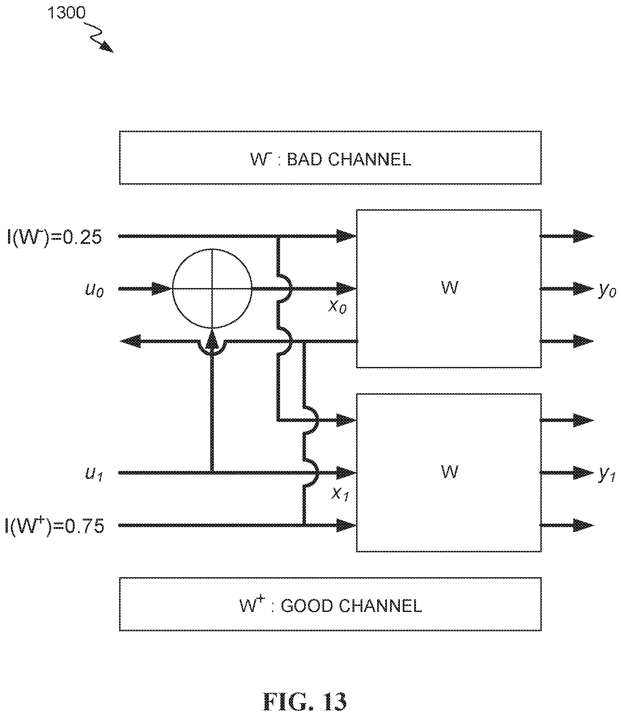

FIG. 13 illustrates a channel polarization system 1300, in accordance with certain aspects of the present disclosure. For a 2-input case, the channel polarization may be carried out by transforming a pair of identical binary-input channels into two distinct channels of different qualities, e.g., one better and one worse than the original binary-input channel. For example, channel W⁻ (e.g., the "bad" channel) may receive an input u0 and have outputs y0 and y1, where u0 = x0⊕x1 = y0⊕y1, with an erasure probability of ε- = 1-(1-*ε*)2 = 2*ε*-*ε*2. Moreover, channel W⁺ (e.g., the "good" channel) may have an input u1 and outputs y0, y1, and u0, where u1= x1 = x0⊕u0 with an erasure probability of ε+ = ε2. The above operation can be performed recursively such that a set of *N* = 2*n* "bit-channels" of varying qualities are obtained. Thus, the information bits may be transmitted over the "good" channel, and known "frozen" bits may be transmitted over the "bad" channel.

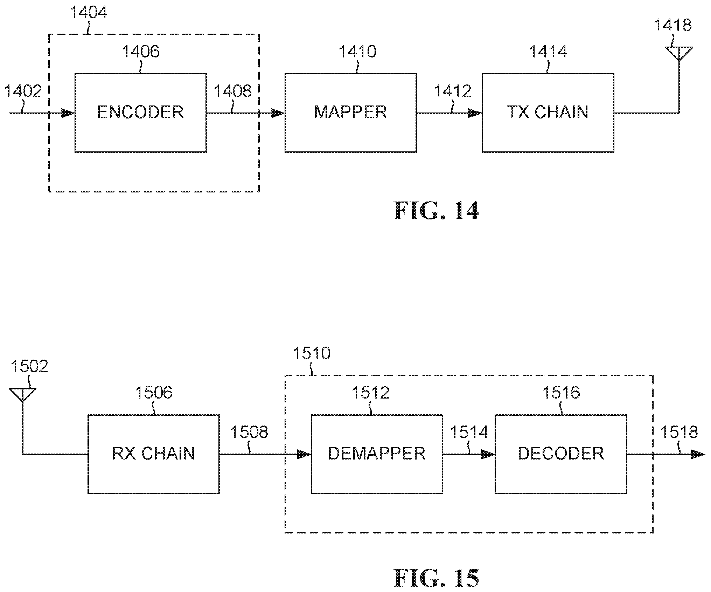

FIG. 14 illustrates certain aspects of an exemplary encoding system. More particularly, FIG. 14 illustrates a portion of an RF modem 1404 that may be configured to provide an encoded message for RF transmission. In one example, an encoder 1406 in a base station (or a UE on the reverse path) receives a message 1402 for transmission. The message 1402 may contain data and/or encoded voice or other content directed to the receiving device. The encoder 1406 encodes the message using a suitable modulation and coding scheme (MCS), typically selected based on a configuration defined by the transmitter system or another network entity. The encoder 1406 may encode the message using the various techniques and method described herein (e.g., with regard to one or more of FIGs. 6-13. An encoded bitstream 1408 produced by the encoder 1406 may then be provided to a mapper 1410 that generates a sequence of Tx symbols 1412 that are modulated, amplified and otherwise processed by Tx chain 1414 to produce an RF signal for transmission through an antenna 1418.

FIG. 15 illustrates certain aspects of an exemplary decoding system. More particularly, FIG. 15 illustrates a portion of an RF modem 1510 that may be configured to receive and decode a wirelessly transmitted signal including an encoded message (e.g., polar-encoded data as described herein). An antenna 1502 receives and provides an RF signal to an Rx chain 1506. The RF signal may be, for example, the RF transmission signal described above with regard to FIG. 14. Rx chain 1506 processes and demodulates the RF signal into a sequence of symbols 1508. A demapper 1512 produces a bitstream 1514 representative of the encoded message from the sequence of symbols 1508.

A decoder 1516 may then be used to decode in-bit information strings from a bitstream that has been encoded using a coding scheme (e.g., a polar code). Decoder 1516 may comprise a Viterbi decoder, an algebraic decoder, a butterfly decoder, or another suitable decoder, which is however not consistent with the claimed invention. In one example, a Viterbi decoder employs the well-known Viterbi algorithm to find the most likely sequence of signaling states (the Viterbi path) that corresponds to a received bitstream 1514. The bitstream 1514 may be decoded based on a statistical analysis of log-likelihood ratios (LLRs) calculated for the bitstream 1514. In one example, a Viterbi decoder may compare and select the correct Viterbi path that defines a sequence of signaling states using a likelihood ratio test to generate LLRs from the bitstream 1514. Likelihood ratios can be used to statistically compare the fit of a plurality of candidate Viterbi paths using a likelihood ratio test that compares the logarithm of a likelihood ratio for each candidate Viterbi path (i.e. the LLR) to determine which path is more likely to account for the sequence of symbols that produced the bitstream 1514. The decoder 1516 may then decode the bitstream 1514 based on the LLRs to determine the message 1518 containing data and/or encoded voice or other content. Decoder 1516 may decode bitstream 1514 in accordance with the various techniques and methods described herein.

FIG. 16 illustrates an exemplary method 1600 for communication. As indicated by block 1602, CRC1 is determined from source data (i.e., information bits). As indicated by block 1604, the source data and CRC1 are concatenated or otherwise attached or combined to form first combined data. As indicated by block 1606, CRC2 is determined from at least one of the source data and the first combined data. As indicated by block 1608, the source data and (e.g., concatenated) CRC1, are combined with (e.g., by further concatenating) CRC2 to form second combined data. As indicated by block 1610, the second combined data is polar encoded to form output data. As indicated by block 1612, the output data may be transmitted over a channel.

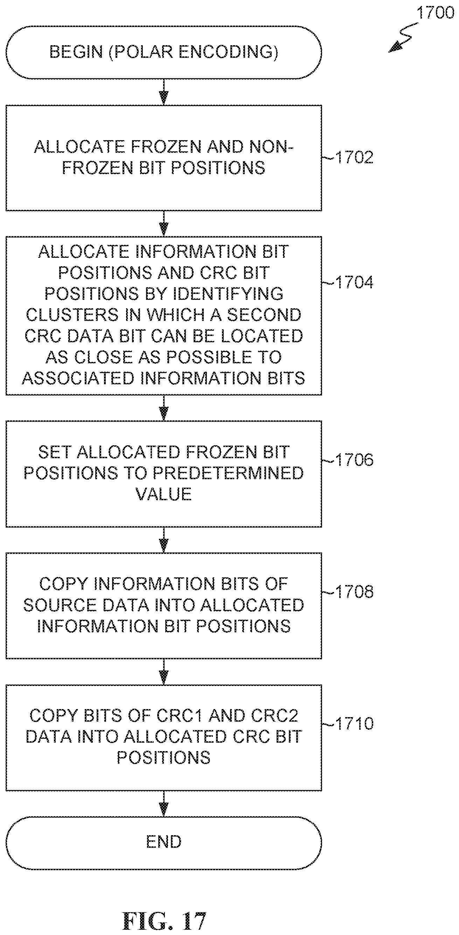

FIG. 17 illustrates an exemplary method 1700 representing an example of the polar encoding described above with regard to block 1610 of FIG. 16. As indicated by block 1702, frozen and non-frozen bit positions in an output data structure are allocated. As indicated by block 1704, information bit positions and CRC bit positions are allocated by using the position management data to identify a cluster of non-frozen bit positions within the output data structure for each CRC2 bit position with the corresponding information bit positions and CRC1 bit positions. The information bit positions and CRC1 bit positions of the cluster are as close as possible to the position of a CRC2 bit. As indicated by block 1706, the allocated frozen bit positions in the output data structure are set to a predetermined value, such as 0 or 1. As indicated by block 1708, information bits of the source data are copied into allocated information bit positions (in the clusters) in the output data structure. As indicated by block 1710, the CRC1 and CRC2 bits are copied into the allocated CRC bit positions (in the clusters) in the output data structure.

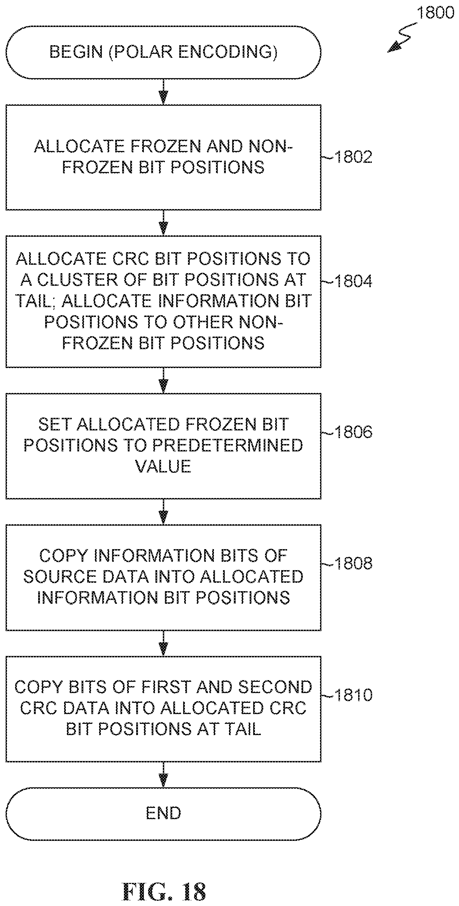

FIG. 18 illustrates an exemplary method 1800 representing another example of the polar encoding described above with regard to 1610 of FIG. 16, which is however not consistent with the claimed invention. As indicated by block 1802, frozen and non-frozen bit positions in an output data structure are allocated. As indicated by block 1804, CRC bit positions are allocated in a cluster at the tail of the data structure, and information bit positions are allocated to other non-frozen bit positions within the output data structure. As indicated by block 1806, the allocated frozen bit positions in the output data structure are set to a predetermined value, such as 0 or 1. As indicated by block 1808, information bits of the source data are copied into allocated information bit positions in the output data structure. As indicated by block 1810, the CRC1 and CRC2 bits are copied into the allocated CRC bit positions in the cluster at the tail of the output data structure.

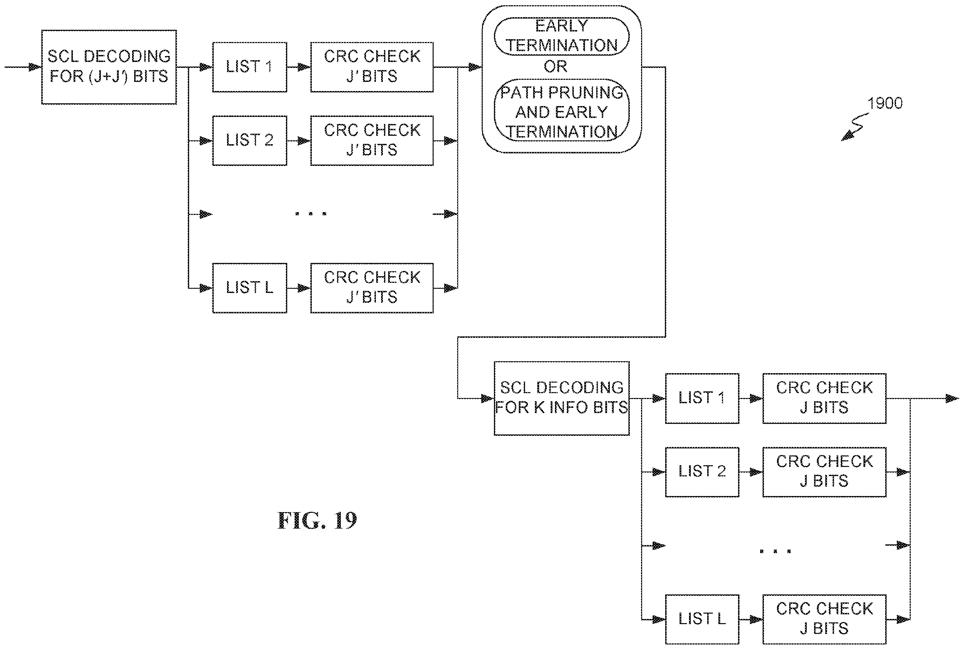

FIG. 19 illustrates an exemplary decoding scheme 1900, which is not consistent with the claimed invention. Due to the assigned lower indices of the J+J' CRC bits, the J+J' CRC bits are decoded first by using an SCL decoder to generate a plurality of decoding paths (List 1 to List L). A CRC check is performed for each of the decoding paths based on the J' CRC bits. If all the paths fail the CRC check, the decoding process will be terminated. Otherwise, the decoding will continue for decoding K information bits. For example, another SCL decoder may be used to decode the K information bits and generate another plurality of decoding paths. Another CRC check is performed for each of the decoding paths based on the J bits CRC to select a final path, as illustrated. Alternatively, for decoding K information bits only the path that passed the CRC check will be considered for the second SCL decoder. In such case, the paths that failed the CRC check will be pruned.

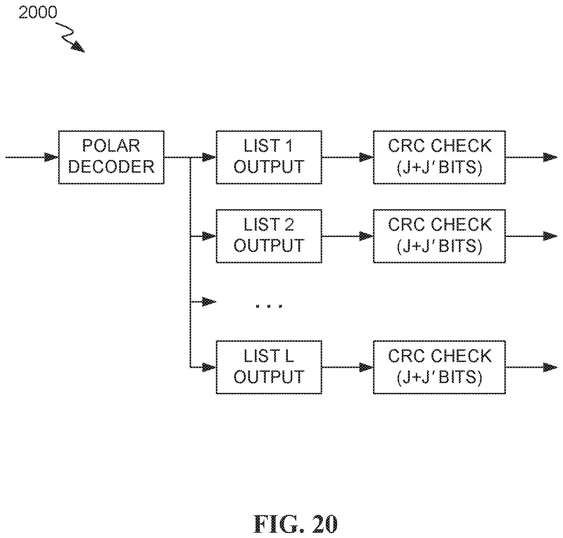

FIG. 20 illustrates another exemplary decoding scheme 2000 which is not consistent with the claimed invention. A list decoder of polar codes outputs L paths. As illustrated, each path may be checked by CRC (e.g., based on the CRC bits J+J'). The path with correct CRC check will be selected for the decoding output. Decoding scheme 2000 may be an example of CA-SCL decoding.

For CA-polar schemes described above, the CRC bits are generated based on all K information bits. Therefore, CRC checking may be performed after the decoding of all the information bits and CRC bits. This means that the decoder may not early-terminate during the decoding. For the blind detection of the downlink (DL) control channel, such as a physical downlink control channel (PDCCH), early termination capability may help reduce decoding power and decoding calculations.

Aspects of the exemplary systems and techniques described above may provide CRC attachment for CA-polar schemes that enables early termination of the decoding, providing benefits that may include, for example, saving power. For example, to generate CRC bits (J+J') a concatenation of two CRC encoders may be used as described above with regard to FIG. 7. As described above, the first J CRC bits may be generated based on K information bits by using a first CRC encoder 702, then the J CRC bits may be used as the input to a second CRC encoder 704 to generate additional J' CRC bits. Then K' = K+J+J' bits are input to a basic polar code generator 708 corresponding to the K' "best" indices of the basic polar codes where J+J' CRC bits have lower indices than that of K information bits. In other words, the J+J' CRC bits and the K information bits are mapped in a decoding order, e.g., the J+J' CRC bits decoded firstly before K information bits. The second J' CRC bits may be used for error detection for early termination, and the first J CRC bits may be used for both error detection and error correction in CA-SCL decoding.

FIG. 21 illustrates an exemplary method 2100 for communication which is not consistent with the claimed invention. Method 2100 may relate to decoding received data. Method 2100 may be performed by a UE, base station, or other system.

As indicated by block 2102, polar codes are received. The received polar codes are characterized by having been generated based on information bits, first CRC data, and second CRC data. As indicated by block 2104, at least one of the first or second CRC data of the polar codes is decoded to generate a set of decoding paths. As indicated by block 2106, a first CRC check is performed based on at least one of the first or second CRC data for each of the decoding paths. As indicated by block 2108, the method 2100 may continue by terminating decoding operations if the CRC check fails for all the decoding paths, or decoding the information bits of the polar codes for one or more of the decoding paths if the CRC check passes for the one or more decoding paths.

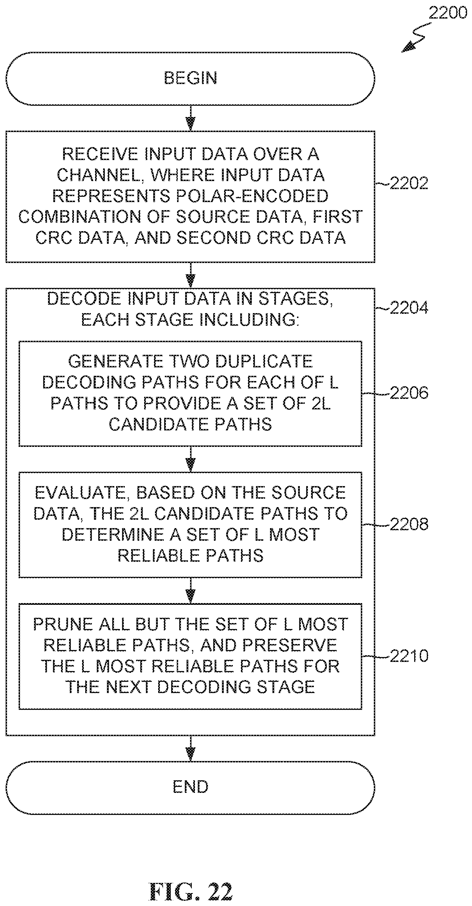

FIG. 22 illustrates an exemplary method 2200 for communication. Method 2200 may relate to decoding received data. Method 2200 may be an example of above-described method 2100 (FIG. 21). As indicated by block 2202, the received input data may be encoded as described above. Accordingly, the input data may represent a polar-encoded combination of source data, first CRC data, and second CRC data. As indicated by block 2204, the input data may be decoded in stages. Except as set forth in this disclosure, the input data may be decoded in accordance with conventional CA-SCL principles, which are well known to one of ordinary skill in the art.

Although CA-SCL decoding is well known, it may be useful to the following description to note certain prominent principles. For example, the information bits are successively decoded in a recursive manner. Referring briefly to source data 1002 in FIGs. 10A-10B and FIGs. 11-12, the first information bit u_1 is analyzed at a first stage of the method by generating and analyzing two candidate paths: a first path in which it may be decided that the first information bit u_1 has a value of 0 and a second path in which it may be decided that u_1 has a value of 1. For each of those paths relating to u_1, two additional candidate paths are generated and analyzed: a first path in which it may be decided that the next information bit u_2 has a value of 0 and a second path in which it may be decided that u_2 has a value of 1. In this manner, a tree is generated and analyzed. That is, the data structures (not shown) representing a parent decoding path are duplicated at each stage, and one of the duplicates (copies) of the parent decoding path is appended to each of the two branches that represent the two decision possibilities.

Thus, as indicated by block 2206, the decoding (block 2204) may include, at each stage, generating two duplicate decoding paths for each of L paths, to provide a set of 2L candidate paths, where L represents a list size. As indicated by block 2208, the decoding (block 2204) may also include evaluating, based on the source data, the 2L candidate paths to determine a set of L most reliable paths. Some or all aspects of blocks 2206, 2208, and 2210 may be conventional. As indicated by block 2210, the decoding (block 2204) may further include removing or pruning from the list all but the set of L most reliable path, and preserving the L most reliable paths for analysis in the next decoding stage. For purposes of clarity, the use of CRC1 and CRC2 is not explicitly described above with regard to the exemplary decoding (block 2204). However, it is understood by one of ordinary skill in the art that in conventional CA-SCL decoding, CRC data may be used to remove or prune from the list all paths that do not pass a CRC parity check before following the most likely, i.e., reliable, path based on the source data.

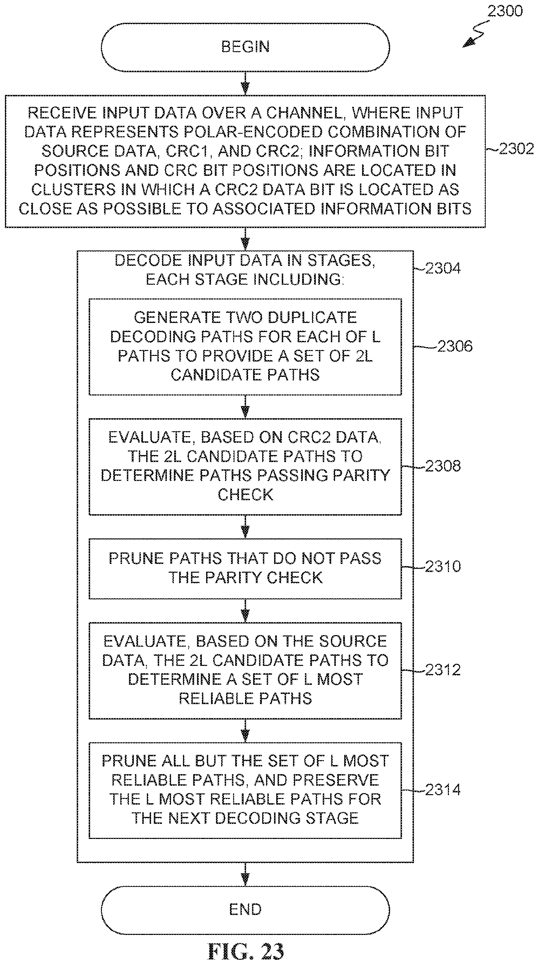

FIG. 23 illustrates an exemplary method 2300 for communication that is similar to above-described exemplary method 2200 but includes an example of how CRC1 and CRC2 may be used to facilitate early pruning. As indicated by block 2302, the received input data may be encoded as described above. Accordingly, the input data may represent a polar-encoded combination of source data, CRC1, and CRC2. As indicated by block 2304, the input data may be decoded in stages. As indicated by block 2306, the decoding (block 2304) may include, at each stage, generating two duplicate decoding paths for each of L paths, to provide a set of 2L candidate paths. As indicated by block 2308, the decoding (block 2304) may also include evaluating, based on CRC2, the 2L candidate paths to determine paths passing a parity check. As indicated by block 2310, decoding (block 2304) may include removing or pruning paths that do not pass this parity check based on CRC2. As indicated by block 2312, decoding (block 2304) may include evaluating, based on the source data, the 2L candidate paths to determine a set of L most reliable paths. The early pruning (block 2310) may enhance the efficiency of this evaluation (block 2312) by first removing paths that cannot be correct from consideration. As indicated by block 2312, the decoding (block 2304) may further include removing or pruning from the list all but the set of L most reliable path, and preserving the L most reliable paths for analysis in the next decoding stage.

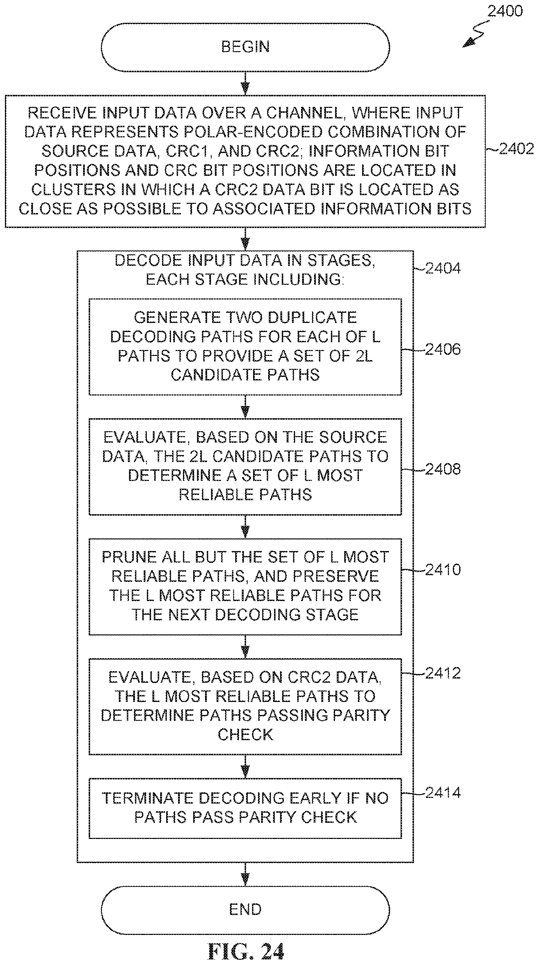

FIG. 24 illustrates an exemplary method 2400 for communication that is similar to above-described exemplary method 2200 (FIG. 22) but includes an example of how CRC1 and CRC2 may be used to facilitate early decoding termination. As indicated by block 2402, the received input data may be encoded as described above. Accordingly, the input data represents a polar-encoded combination of source data, CRC1, and CRC2. As indicated by block 2404, the input data may be decoded in stages. As indicated by block 2406, the decoding (block 2404) includes at each stage, generating two duplicate decoding paths for each of L paths, to provide a set of 2L candidate paths. As indicated by block 2408, decoding (block 2404) includes evaluating, based on the source data, the 2L candidate paths to determine a set of L most reliable paths. As indicated by block 2410, the decoding (block 2404) further includes removing or pruning from the list all but the set of L most reliable path, and preserving the L most reliable paths for analysis in the next decoding stage. As indicated by block 2412, the decoding (block 2404) also includes evaluating, based on CRC2, the 2L candidate paths remaining after pruning (block 2410) to determine paths passing a parity check. As indicated by block 2414, decoding (block 2404) further includes terminating decoding if none of the paths pass the parity check.

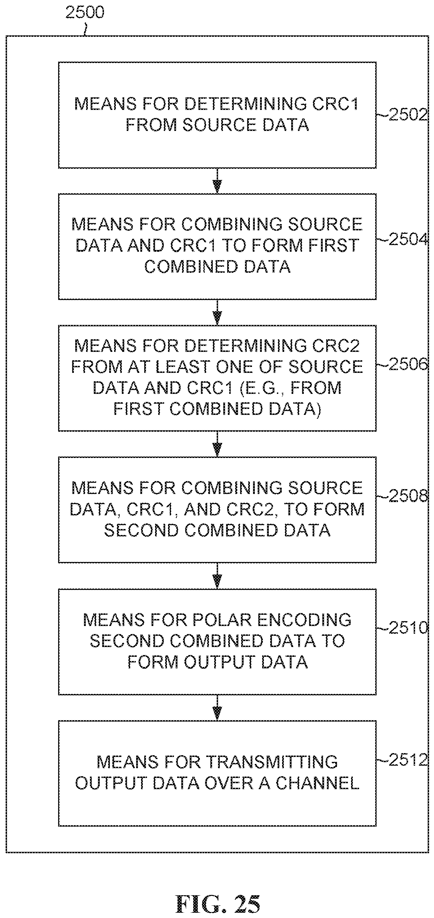

FIG. 25 illustrates an apparatus 2500 for a communication system in accordance with various aspects of the present disclosure. The apparatus 2500 comprises means 2502 for determining first cyclic redundancy check (CRC) data from source data, means 2504 for combining the source data and the first CRC data to form first combined data, means 2506 for determining second cyclic redundancy check (CRC) data from the first combined data, means 2508 for combining the source data, the first CRC data, and the second CRC data to form second combined data, means 2510 for polar coding the second combined data to form output data, and means 2512 for transmitting the output data over a channel. The means 2502-2512 may be configured to perform one or more of the functions described above with regard to blocks 1602-1612 (FIG. 16), respectively. In exemplary embodiments, such functions may be controlled by encoder 208 (FIG. 2), channel coding system 318 (FIG. 3), encoder 522 (FIG. 5), or other encoding element.

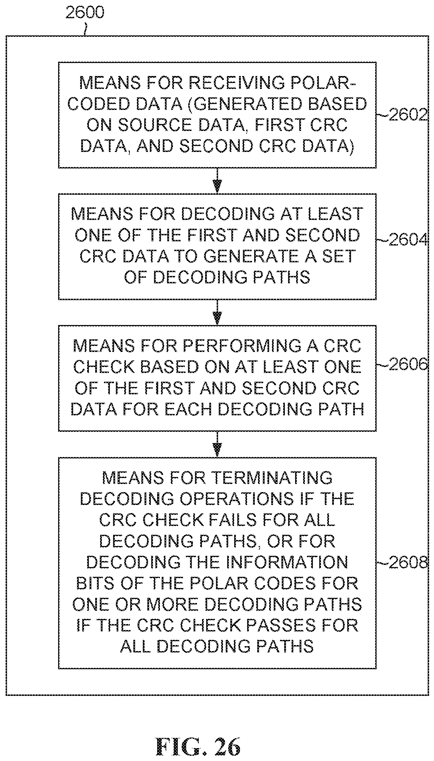

FIG. 26 illustrates an apparatus 2600 for a communication system which is not consistent with the claimed invention. The apparatus 2600 comprises means 2602 for receiving polar-coded data, means 2604 for decoding at least one of first and second CRC data to generate a set of decoding paths, means 2608 for performing a CRC check based on at least of first and second CRC data for each decoding path, and means 2610 for terminating decoding operations if the CRC check fails for all decoding paths or for decoding the information bits of the polar-coded data if the CRC check passes for all decoding paths. The means 2602-2610 may be configured to perform one or more of the functions described above with regard to blocks 2102-2108 (FIG. 21), respectively. In exemplary embodiments, such functions may be controlled by decoder 230 (FIG. 2), channel coding system 318 (FIG. 3), decoder 524 (FIG. 5), or other decoding element.

Aspects of the present disclosure may provide various benefits. For example, the CRC attaching or combining may be implemented by using a shifter register with low implementation complexity. Moreover, a similar block error rate (BLER) and FAR performance may obtained as compared to CA-polar with the same number of CRC bits but with reduced implementation complexity, e.g., no additional efforts for permutation of CRC generator matrix. The techniques provided herein may also provide improved early termination performance because if early termination is activated, the resulting skipping of decoding information bits saves power. In addition, aspects of the present disclosure may provide a high early termination ratio (e.g., about 69%) for noise input to the decoder and about 50% for unwanted signal input (e.g., assuming J+J'=16 and list size = 8 in a simulation).

Techniques described herein may be used in various wireless communications systems such as CDMA, TDMA, FDMA, OFDMA, SC-FDMA, and other systems. The terms "system" and "network" are often used interchangeably. A CDMA system may implement a radio technology such as CDMA2000, Universal Terrestrial Radio Access (UTRA), etc. CDMA2000 covers IS-2000, IS-95, and IS-856 standards. IS-2000 Releases 0 and A are commonly referred to as CDMA2000 1x, 1x, etc. IS-856 (TIA-856) is commonly referred to as CDMA2000 IxEV-DO, High Rate Packet Data (HRPD), etc. UTRA includes Wideband CDMA (WCDMA) and other variants of CDMA. A TDMA system may implement a radio technology such as Global System for Mobile Communications (GSM). An OFDMA system may implement a radio technology such as Ultra Mobile Broadband (UMB), Evolved UTRA (E-UTRA), IEEE 802.11 (Wi-Fi), IEEE 802.16 (WiMAX), IEEE 802.20, Flash-OFDM.TM., etc. UTRA and E-UTRA are part of Universal Mobile Telecommunication System (UMTS). 3GPP Long Term Evolution (LTE) and LTE-Advanced (LTE-A) are new releases of UMTS that use E-UTRA. UTRA, E-UTRA, UMTS, LTE, LTE-A, and GSM are described in documents from an organization named "3rd Generation Partnership Project" (3GPP). CDMA2000 and UMB are described in documents from an organization named "3rd Generation Partnership Project 2" (3GPP2). The techniques described herein may be used for the systems and radio technologies mentioned above as well as other systems and radio technologies, including cellular (e.g., LTE) communications over an unlicensed and/or shared bandwidth. The description above, however, describes an LTE/LTE-A system for purposes of example, and LTE terminology is used in much of the description above, although the techniques are applicable beyond LTE/LTE-A applications.

The detailed description set forth above in connection with the appended drawings describes examples and does not represent the only examples that may be implemented or that are within the scope of the claims. The terms "example" and "exemplary," when used in this description, mean "serving as an example, instance, or illustration," and not "preferred" or "advantageous over other examples." The detailed description includes specific details for the purpose of providing an understanding of the described techniques. These techniques, however, may be practiced without these specific details. In some instances, well-known structures and apparatuses are shown in block diagram form in order to avoid obscuring the concepts of the described examples.

Information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

The various illustrative blocks and components described in connection with the disclosure herein may be implemented or performed with a general-purpose processor, a digital signal processor (DSP), an ASIC, an FPGA or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, multiple microprocessors, one or more microprocessors in conjunction with a DSP core, or any other such configuration. 1402

The functions described herein may be implemented in hardware, software executed by a processor, firmware, or any combination thereof. If implemented in software executed by a processor, the functions may be stored on or transmitted over as one or more instructions or code on a computer-readable medium. Other examples and implementations are within the scope and spirit of the disclosure and appended claims. For example, due to the nature of software, functions described above can be implemented using software executed by a processor, hardware, firmware, hardwiring, or combinations of any of these. Features implementing functions may also be physically located at various positions, including being distributed such that portions of functions are implemented at different physical locations. As used herein, including in the claims, the term "and/or," when used in a list of two or more items, means that any one of the listed items can be employed by itself, or any combination of two or more of the listed items can be employed. For example, if a composition is described as containing components A, B, and/or C. the composition can contain A alone; B alone; C alone; A and B in combination; A and C in combination; B and C in combination; or A, B, and C in combination. Also, as used herein, including in the claims, "or" as used in a list of items (for example, a list of items prefaced by a phrase such as "at least one of" or "one or more of") indicates a disjunctive list such that, for example, a list of "at least one of A, B, or C" means A or B or C or AB or AC or BC or ABC (i.e., A and B and C).

The previous description of the disclosure is provided to enable a person skilled in the art to make or use the disclosure. Various modifications to the disclosure will be readily apparent to those skilled in the art, and the generic principles defined herein may be applied to other variations without departing from the scope of the claimed invention. Thus, the disclosure is not to be limited to the examples and designs described herein but is to be accorded the broadest scope consistent with the invention as set out by the appended claims.

## Claims

1. A method (1600) for communication, comprising:
determining (1602) first cyclic redundancy check, CRC, data (1004) from source data (1002);
combining (1604) the source data (1002) and the first CRC data (1004) to form first combined data (1006);
determining (1606) second CRC data (1008) from the first combined data (1006);
combining (1608) the source data (1002), the first CRC data (1004), and the second CRC data (1008) to form second combined data;
polar encoding (1610) the second combined data to form polar-encoded data (218), comprising:
allocating (1702) frozen and non-frozen bit positions in an output data structure of the second combined data using reliability index data, the reliability index data relating each bit position of the output data structure of the second combined data to reliability of a corresponding sub-channel; and
allocating (1704), among the non-frozen bit positions, information bit positions for the source data (1002) and CRC bit positions for the first CRC data (1004) and the second CRC data (1008) in the output data structure of the combined second data using position management data to identify at least one cluster (1104A, 1104B) within said output data structure, each cluster (1104A, 1104B) comprising non-frozen bit positions for a portion of the source data (1002), first CRC data (1004) corresponding to the portion of the source data (1002), and second CRC data (1008) that encodes the portion of the source data (1002) and the first CRC data (1004) corresponding to the portion of the source data (1002); and
transmitting (1612) the polar-encoded data (218) over a channel.

2. The method of claim 1, wherein polar encoding the second combined data further comprises:
setting (1706) allocated frozen bit positions in the output data structure of the second combined data to a predetermined value;
copying (1708) information bits of the source data into allocated information bit positions in the output data structure of the second combined data; and
copying (1710) bits of the first and second CRC data into allocated CRC bit positions in the output data structure of the second combined data.

3. The method of claim 1, wherein transmitting the polar-encoded data over a channel comprises transmitting the polar-encoded data over one of a physical downlink control channel and a physical uplink control channel.

4. An apparatus (2500) for communication, comprising:
baseband circuitry for providing source data (1002);
a processing system comprising a processor and memory, the processing system configured to:
determine (2502) first cyclic redundancy check, CRC, data (1004) from the source data (1002);
combine (2504) the source data (1002) and the first CRC data (1004) to form first combined data (1006);
determine (2506) second CRC data (1008) from the first combined data (1006);
combine (2508) the source data (1002), the first CRC data (1004), and the second CRC data (1008) to form second combined data;
polar encode (2510) the second combined data to form polar-encoded data (218), wherein the processing system is configured to:
allocate frozen and non-frozen bit positions in an output data structure (1102) of the second combined data using reliability index data, the reliability index data relating each bit position of the output data structure to reliability of a corresponding sub-channel; and
allocate, among the non-frozen bit positions, information bit positions for the source data and CRC bit positions for the first CRC data (1004) and the second CRC data (1008) in the output data structure of the second combined data using position management data to identify at least one cluster (1104A, 1104B) within said output data structure, each cluster (1104A, 1104B) comprising non-frozen bit positions for a portion of the source data, first CRC data corresponding to the portion of the source data, and second CRC data that encode the portion of the source data and the first CRC data corresponding to the portion of the source data; and
control transmission (2512) of the polar-encoded data (218) over a channel.

5. A method (2100) for communication, comprising:
receiving (2102) input data over a channel, the input data representing a codeword encoded using a polar code on second combined data, the second combined data having an output data structure (1102) and being a combination of source data (1002), second cyclic redundancy check, CRC, data (1008), and first CRC data (1004), the first CRC data (1004) encoding the source data (1002), the second CRC data (1008) encoding first combined data being a combination of the source data (1002) and the first CRC data (1004), wherein the output data structure (1102) of the second combined data comprises at least one cluster (1104A, 1104B) of non-frozen bit positions for a portion of the source data (1002), first CRC data (1004) corresponding to the portion of the source data (1002), and second CRC data (1008) that encodes the portion of the source data (1002) and the first CRC data (1004) corresponding to the portion of the source data (1002);
decoding (2404) the received input data by successive cancellation list, SCL, decoding with a list size L, wherein the decoding comprises using a plurality of successive decoding stages to obtain recursively the source data, the first CRC data and the second CRC data by, at each stage:
generating (2406) exactly two duplicate decoding paths for each of L paths to provide a set of 2L candidate paths, the two duplicate decoding paths representing respective decisions of 0 and 1, where L is an integer greater than 1;
evaluating (2408), based on the source data, the set of 2L candidate paths to determine a set of L most reliable paths out of the set of 2L candidate paths;
removing (2410) from further evaluation all but the set of L most reliable paths, and preserving the set of L most reliable paths for a next decoding stage; performing a first CRC check using the second CRC data (1008) for each of the decoding paths as early in the decoding process as possible, comprising evaluating (2412), based on the second CRC data (1008), the set of L most reliable paths to determine a subset of paths passing CRC parity check; and
terminating (2414) decoding operations if the subset of paths passing CRC parity check is empty.

6. The method of claim 5, wherein:
decoding the input data using a plurality of successive decoding stages further comprises instead of evaluating (2412), based on the second CRC data, the set of L most reliable paths and before the step of evaluating (2408) based on the source data evaluating (2308), based on the second CRC data and as early in the decoding process as possible, the set of 2L candidate paths to determine a subset of paths passing CRC parity check; and
removing from further evaluation all but the subset of paths passing the CRC parity check, and
preserving the subset of paths passing the CRC parity check for further evaluation

7. The method of claim 5, wherein receiving input data over a channel comprises receiving the input data over one of a physical downlink control channel and a physical uplink control channel.

8. An apparatus (500) for communication, comprising:
receiver circuitry (512) configured to receive input data over a channel, the input data representing a codeword encoded using a polar code on second combined data, the second combined data having an output data structure (1102) and being a combination of source data (1002), second cyclic redundancy check, CRC, data (1008), and first CRC data (1004), the first CRC data (1004) encoding the source data (1002), the second CRC data (1008) encoding first combined data being a combination of the source data (1002) and the first CRC data (1004), wherein the output data structure (1102) of the second combined data comprises at least one cluster (1104A, 1104B) of non-frozen bit positions for a portion of the source data (1002), first CRC data (1004) corresponding to the portion of the source data (1002), and second CRC data (1008) that encodes the portion of the source data (1002) and the first CRC data (1004) corresponding to the portion of the source data (1002); and
a processing system comprising a processor (504) and memory (506), the processing system configured to:
receive the input data over a channel,
decode the received input data by successive cancellation list, SCL, decoding with a list size L, wherein the decoding comprises using a plurality of successive decoding stages to obtain recursively the source data, the first CRC data and the second CRC data, and at each stage the processing system is configured to:
generate exactly two duplicate decoding paths for each of L paths to provide a set of 2L candidate paths, the two duplicate decoding paths representing respective decisions of 0 and 1, where L is an integer greater than 1;
evaluate, based on the source data, the set of 2L candidate paths to determine a set of L most reliable paths out of the set of 2L candidate paths;
remove from further evaluation all but the set of L most reliable paths, and preserving the set of L most reliable paths for a next decoding stage;
perform a first CRC check using the second CRC data (1008) for each of the decoding paths as early in the decoding process as possible, comprising the processing system is configured to evaluate, based on the second CRC data (1008), the set of L most reliable paths to determine a subset of paths passing CRC parity check; and
terminate decoding operations if the subset of paths passing CRC parity check is empty.

## Patentansprüche

1. Ein Verfahren (1600) für Kommunikation, das Folgendes aufweist:
Bestimmen (1602) erster CRC-Daten (CRC = cyclic redundancy check bzw. zyklische Redundanzprüfung) (1004) aus Source-Daten bzw. Quellendaten (1002);
Kombinieren (1604) der Quellendaten (1002) und der ersten CRC-Daten (1004) zum Bilden erster kombinierter Daten (1006);
Bestimmen (1606) zweiter CRC-Daten (1008) aus den ersten kombinierten Daten (1006);
Kombinieren (1608) der Source-Daten (1002), der ersten CRC-Daten (1004) und der zweiten CRC-Daten (1008) zum Bilden zweiter kombinierter Daten;
Polarcodieren (1610) der zweiten kombinierten Daten zum Bilden von polarcodierten Daten (218), das Folgendes aufweist:
Zuteilen (1702) von eingefrorenen und nicht eingefrorenen Bitpositionen in einer Ausgangsdatenstruktur der zweiten kombinierten Daten unter Nutzung von Zuverlässigkeitsindexdaten, wobei die Zuverlässigkeitsindexdaten jede Bitposition der Ausgangsdatenstruktur der zweiten kombinierten Daten mit einer Zuverlässigkeit eines entsprechenden Subkanals in Beziehung setzen; und
Zuteilen (1704), unter den nicht eingefrorenen Bitpositionen, von Informationsbitpositionen für die Quellendaten (1002) und CRC-Bit-Positionen für die ersten CRC-Daten (1004) und die zweiten CRC-Daten (1008) in der Ausgangsdatenstruktur der kombinierten zweiten Daten unter Nutzung von Positionsverwaltungsdaten zum Identifizieren wenigstens eines Clusters (1104A, 1104B) innerhalb der Ausgangsdatenstruktur, wobei jedes Cluster (1104A, 1104B) Folgendes aufweist: nicht eingefrorene Bitpositionen für einen Teil der Quellendaten (1002), erste CRC-Daten (1004), die dem Teil der Quellendaten (1002) entsprechen, und zweite CRC-Daten (1008), die den Teil der Quellendaten (1002) und die ersten CRC-Daten (1004), die dem Teil der Quellendaten (1002) entsprechen, codieren; und
Senden (1612) der polarcodierten Daten (218) über einen Kanal.

2. Verfahren nach Anspruch 1, wobei Polarcodieren der zweiten kombinierten Daten weiter Folgendes aufweist:
Setzen (1706) von zugeteilten eingefrorenen Bitpositionen in der Ausgangsdatenstruktur der zweiten kombinierten Daten auf einen vorbestimmten Wert;
Kopieren (1708) von Informationsbits der Quellendaten in zugeteilte Informationsbitpositionen in der Ausgangsdatenstruktur der zweiten kombinierten Daten; und
Kopieren (1710) von Bits der ersten und zweiten CRC-Daten in zugeteilte CRC-Bit-Positionen in der Ausgangsdatenstruktur der zweiten kombinierten Daten.

3. Verfahren nach Anspruch 1, wobei Senden der polarcodierten Daten über einen Kanal Senden der polarcodierten Daten über eines von einem physischen Abwärtsstreckensteuerkanal und einem physischen Aufwärtsstreckensteuerkanal aufweist.

4. Eine Vorrichtung (2500) für Kommunikation, die Folgendes aufweist:
Basisbandschaltkreise zum Vorsehen von Quellendaten (1002);
ein Verarbeitungssystem, das einen Prozessor und einen Speicher aufweist, wobei das Verarbeitungssystem konfiguriert ist zum:
Bestimmen (2502) von ersten CRC-Daten (CRC = cyclic redundancy check) (1004) aus den Quellendaten (1002);
Kombinieren (2504) der Quellendaten (1002) und der ersten CRC-Daten (1004) zum Bilden erster kombinierter Daten (1006);
Bestimmen (2506) zweiter CRC-Daten (1008) aus den ersten kombinierten Daten (1006);
Kombinieren (2508) der Quellendaten (1002), der ersten CRC-Daten (1004) und der zweiten CRC-Daten (1008) zum Bilden von zweiten kombinierten Daten;
Polarcodieren (2510) der zweiten kombinierten Daten zum Bilden von polarcodierten Daten (218), wobei das Verarbeitungssystem konfiguriert ist zum:
Zuteilen von eingefrorenen und nicht eingefrorenen Bitpositionen in einer Ausgangsdatenstruktur (1102) der zweiten kombinierten Daten unter Nutzung von Zuverlässigkeitsindexdaten, wobei Zuverlässigkeitsindexdaten jede Bitposition der Ausgangsdatenstruktur mit einer Zuverlässigkeit eines entsprechenden Subkanals in Beziehung setzen; und
Zuteilen, unter den nicht eingefrorenen Bitpositionen, von Informationsbitpositionen für die Quellendaten und CRC-Bit-Positionen für die ersten CRC-Daten (1004) und die zweiten CRC-Daten (1008) in der Ausgangsdatenstruktur der zweiten kombinierten Daten unter Nutzung von Positionsverwaltungsdaten zum Identifizieren wenigstens eines Clusters (1104A, 1104B) innerhalb der Ausgangsdatenstruktur, wobei jedes Cluster (1104A, 1104B) Folgendes aufweist: nicht eingefrorene Bitpositionen für einen Teil der Quellendaten, erste CRC-Daten, die dem Teil der Quellendaten entsprechen, und zweite CRC-Daten, die den Teil der Quellendaten und die ersten CRC-Daten, die dem Teil der Quellendaten entsprechen, codieren; und
Steuern einer Sendung (2512) der polarcodierten Daten (218) über einen Kanal.

5. Ein Verfahren (2100) für Kommunikation, das Folgendes aufweist:
Empfangen (2102) von Eingangsdaten über einen Kanal, wobei die Eingangsdaten ein Codewort darstellen, das codiert ist unter Nutzung eines Polarcodes auf zweiten kombinierten Daten, wobei die zweiten kombinierten Daten eine Ausgangsdatenstruktur (1102) haben und eine Kombination sind von Quellendaten (1002), zweiten CRC-Daten (CRC = cyclic redundancy check bzw. zyklische Redundanzprüfung) (1008) und ersten CRC-Daten (1004), wobei die ersten CRC-Daten (1004) die Quellendaten (1002) codieren, die zweiten CRC-Daten (1008) erste kombinierte Daten codieren, die eine Kombination der Quellendaten (1002) und der ersten CRC-Daten (1004) sind, wobei die Ausgangsdatenstruktur (1102) der zweiten kombinierten Daten wenigstens ein Cluster (1104A, 1104B) aus Folgendem aufweist: nicht eingefrorenen Bitpositionen für einen Teil der ersten Quellendaten (1002), ersten CRC-Daten (1004), die dem Teil der Quellendaten (1002) entsprechen, und zweiten CRC-Daten (1008), die den Teil der Quellendaten (1002) und erste CRC-Daten (1004), die dem Teil der Quellendaten (1002) entsprechen, codieren;
Decodieren (2404) der empfangenen Eingangsdaten durch SCL-Decodierung (SCL = successive cancellation list bzw. Liste sukzessiver Löschung) mit einer Listengröße L, wobei das Decodieren Nutzen einer Vielzahl von sukzessiven Decodierungsstufen aufweist zum rekursiven Erlangen der Quellendaten, der ersten CRC-Daten und der zweiten CRC-Daten durch, auf jeder Stufe:
Generieren (2406) von exakt zwei duplizierten Decodierungspfaden für jeden von L Pfaden zum Vorsehen eines Satzes von 2L Kandidatenpfaden, wobei die zwei duplizierten Decodierungspfade jeweilige Entscheidungen von 0 und 1 darstellen, wobei L eine ganze Zahl größer als 1 ist;
Evaluieren (2408), basierend auf den Quellendaten, des Satzes von 2L Kandidatenpfaden, um einen Satz von L zuverlässigsten Pfaden aus dem Satz von 2L Kandidatenpfaden zu bestimmen;
Entfernen (2410), aus einer weiteren Evaluierung, von allen außer dem Satz von L zuverlässigsten Pfaden, und
Bewahren des Satzes von L zuverlässigsten Pfaden für eine nächste Decodierungsstufe;
Durchführen einer ersten CRC-Prüfung unter Nutzung der zweiten CRC-Daten (1008) für jeden der Decodierungspfade so früh in dem Decodierungsprozess wie möglich, was Evaluieren (2412), basierend auf den zweiten CRC-Daten (1008) des Satzes von L zuverlässigsten Pfaden aufweist, um einen Subsatz von Pfaden zu bestimmen, die eine CRC-Paritätsprüfung bestehen; und
Beenden (2414) von Decodierungsoperationen, wenn der Subsatz von Pfaden, die die CRC-Paritätsprüfung bestehen, leer ist.

6. Verfahren nach Anspruch 5, wobei:
Decodieren der Eingangsdaten unter Nutzung einer Vielzahl von aufeinanderfolgenden Decodierungsstufen weiter, anstatt Evaluieren (2412), basierend auf den zweiten CRC-Daten, des Satzes von L zuverlässigsten Pfaden, und vor dem Schritt des Evaluierens (2408) basierend auf den Quellendaten, Folgendes aufweist:
Evaluieren (2308), basierend auf den zweiten CRC-Daten und so früh wie möglich in dem Decodierungsprozess, des Satzes von 2L Kandidatenpfaden, um einen Subsatz von Pfaden zu bestimmen, die eine CRC-Paritätsprüfung bestehen; und
Entfernen, aus weiterer Evaluation, aller außer dem Subsatz von Pfaden, die die CRC-Paritätsprüfung bestehen; und
Bewahren des Subsatzes von Pfaden, die die CRC-Paritätsprüfung bestehen, für weitere Evaluation.

7. Verfahren nach Anspruch 5, wobei Empfangen von Eingangsdaten über einen Kanal Folgendes aufweist:
Empfangen der Eingangsdaten über einen physischen Abwärtsstreckensteuerkanal und einen physischen Aufwärtsstreckensteuerkanal.

8. Eine Vorrichtung (500) für Kommunikation, die Folgendes aufweist:
Empfängerschaltkreise (512), die konfiguriert sind zum Empfangen von Eingangsdaten über einen Kanal, wobei die Eingangsdaten ein Codewort darstellen, das unter Nutzung eines Polarcodes codiert ist, und zwar auf zweiten kombinierten Daten, wobei die zweiten kombinierten Daten eine Ausgangsdatenstruktur (1102) haben und eine Kombination von Source- bzw. Quellendaten (1002), zweiten CRC-Daten (CRC = cyclic redundancy check bzw. zyklische Redundanzprüfung) (1008) und ersten CRC-Daten (1004) sind, wobei die ersten CRC-Daten (1004) die Quellendaten (1002) codieren, die zweiten CRC-Daten (1008) erste kombinierte Daten, die eine Kombination der Quellendaten (1002) und der ersten CRC-Daten (1004) sind, codieren, wobei die Ausgangsdatenstruktur (1102) der zweiten kombinierten Daten wenigstens ein Cluster (1104A, 1104B) aufweist von nicht eingefrorenen Bitpositionen für einen Teil der Quellendaten (1002), ersten CRC-Daten (1004), die dem Teil der Quellendaten (1002) entsprechen, und zweiten CRC-Daten (1008), die den Teil der Quellendaten (1002) und die ersten CRC-Daten (1004), die dem Teil der Quellendaten (1002) entsprechen, codieren; und
ein Verarbeitungssystem, das einen Prozessor (504) und einen Speicher (506) aufweist, wobei das Verarbeitungssystem konfiguriert ist zum:
Empfangen der Eingangsdaten über einen Kanal,
Decodieren der empfangenen Eingangsdaten durch SCL-Decodierung (SCL = successive cancellation list bzw. Liste sukzessiver Löschung) mit einer Listengröße L, wobei das Decodieren Nutzen einer Vielzahl von sukzessiven Decodierungsstufen aufweist zum rekursiven Erlangen der Quellendaten, der ersten CRC-Daten und der zweiten CRC-Daten, und das Verarbeitungssystem auf jeder Stufe konfiguriert ist zum:
Generieren von exakt zwei duplizierten Decodierungspfaden für jeden von L Pfaden zum Vorsehen eines Satzes von 2L Kandidatenpfaden, wobei die zwei duplizierten Decodierungspfade jeweilige Entscheidungen von 0 und 1 darstellen, wobei L eine ganze Zahl größer als 1 ist;
Evaluieren, basierend auf den Quellendaten, des Satzes von 2L Kandidatenpfaden, um einen Satz von L zuverlässigsten Pfaden aus dem Satz von 2L Kandidatenpfaden zu bestimmen;
Entfernen, aus einer weiteren Evaluierung, von allen außer dem Satz von L zuverlässigsten Pfaden, und
Bewahren des Satzes von L zuverlässigsten Pfaden für eine nächste Decodierungsstufe;
Durchführen einer ersten CRC-Prüfung unter Nutzung der zweiten CRC-Daten (1008) für jeden der Decodierungspfade so früh in dem Decodierungsprozess wie möglich, was aufweist, dass das Verarbeitungssystem konfiguriert ist zum Evaluieren, basierend auf den zweiten CRC-Daten (1008) des Satzes von L zuverlässigsten Pfaden, um einen Subsatz von Pfaden zu bestimmen, die eine CRC-Paritätsprüfung bestehen; und
Beenden von Decodierungsoperationen, wenn der Subsatz von Pfaden, die die CRC-Paritätsprüfung bestehen, leer ist.

## Revendications

1. Un procédé (1600) de communication, comprenant :
la détermination (1602) de premières données de contrôle de redondance cyclique, CRC, (1004) provenant de données sources (1002),
la combinaison (1604) des données sources (1002) et des premières données CRC (1004) de façon à former des premières données combinées (1006),
la détermination (1606) de deuxièmes données CRC (1008) à partir des premières données combinées (1006),
la combinaison (1608) des données sources (1002), des premières données CRC (1004) et des deuxièmes données CRC (1008) de façon à former des deuxièmes données combinées,
le codage polaire (1610) des deuxièmes données combinées de façon à former des données à codage polaire (218) comprenant :
l'attribution (1702) de positions binaires gelées et non gelées dans une structure de données en sortie des deuxièmes données combinées au moyen de données d'indice de fiabilité, les données d'indice de fiabilité reliant chaque position binaire de la structure de données en sortie des deuxièmes données combinées à une fiabilité d'un sous-canal correspondant, et
l'attribution (1704), parmi les positions binaires non gelées, de positions binaires d'informations pour les données sources (1002) et de positions binaires CRC pour les premières données CRC (1004) et les deuxièmes données CRC (1008) dans la structure de données en sortie des deuxièmes données combinées au moyen de données de gestion de positions de façon à identifier au moins une grappe (1104A, 1104B) à l'intérieur de ladite structure de données en sortie, chaque grappe (1104A, 1104B) comprenant des positions binaires non gelées pour une partie des données sources (1002), des premières données CRC (1004) correspondant à la partie des données sources (1002), et des deuxièmes données CRC (1008) qui codent la partie des données sources (1002) et les premières données CRC (1004) correspondant à la partie des données sources (1002), et
la transmission (1612) des données à codage polaire (218) par l'intermédiaire d'un canal.

2. Le procédé selon la Revendication 1, où le codage polaire des deuxièmes données combinées comprend en outre :
le réglage (1706) de positions binaires gelées attribuées dans la structure de données en sortie des deuxièmes données combinées sur une valeur prédéterminée,
la copie (1708) de bits d'informations des données sources vers des positions binaires d'informations attribuées dans la structure de données en sortie des deuxièmes données combinées, et
la copie (1710) de bits des premières et deuxièmes données CRC vers des positions binaires CRC attribuées dans la structure de données en sortie des deuxièmes données combinées.

3. Le procédé selon la Revendication 1, où la transmission des données à codage polaire par l'intermédiaire d'un canal comprend la transmission des données à codage polaire par l'intermédiaire d'un canal parmi un canal de commande en liaison descendante physique et un canal de commande en liaison montante physique.

4. Un appareil (2500) de communication, comprenant :
un ensemble de circuits de bande de base destiné à la fourniture de données sources (1002),
un système de traitement comprenant un processeur et une mémoire, le système de traitement étant configuré de façon à :
déterminer (2502) des premières données de contrôle de redondance cyclique, CRC, (1004) à partir des données sources (1002),
combiner (2504) les données sources (1002) et les premières données CRC (1004) de façon à former des premières données combinées (1006),
déterminer (2506) des deuxièmes données CRC (1008) à partir des premières données combinées (1006),
combiner (2508) les données sources (1002), les premières données CRC (1004) et les deuxièmes données CRC (1008) de façon à former des deuxièmes données combinées,
coder polaire (2510) les deuxièmes données combinées de façon à former des données à codage polaire (218) où le système de traitement est configuré de façon à :
attribuer des positions binaires gelées et non gelées dans une structure de données en sortie (1102) des deuxièmes données combinées au moyen de données d'indice de fiabilité, les données d'indice de fiabilité reliant chaque position binaire de la structure de données en sortie à une fiabilité d'un sous-canal correspondant, et
attribuer, parmi les positions binaires non gelées, des positions binaires d'informations pour les données sources et des positions binaires CRC pour les premières données CRC (1004) et les deuxièmes données CRC (1008) dans la structure de données en sortie des deuxièmes données combinées au moyen de données de gestion de positions de façon à identifier au moins une grappe (1104A, 1104B) à l'intérieur de ladite structure de données en sortie, chaque grappe (1104A, 1104B) comprenant des positions binaires non gelées pour une partie des données sources, des premières données CRC correspondant à la partie des données sources et les deuxièmes données CRC qui codent la partie des données sources et les premières données CRC correspondant à la partie des données sources, et
commander la transmission (2512) des données à codage polaire (218) par l'intermédiaire d'un canal.

5. Un procédé (2100) de communication, comprenant :
la réception (2102) de données en entrée par l'intermédiaire d'un canal, les données en entrée représentant un mot de code codé au moyen d'un code polaire sur des deuxièmes données combinées, les deuxièmes données combinées possédant une structure de données en sortie (1102) et étant une combinaison de données sources (1002), de deuxièmes données de contrôle de redondance cyclique, CRC (1008), et de premières données CRC (1004), les premières données CRC (1004) codant les données sources (1002), les deuxièmes données CRC (1008) codant les premières données combinées étant une combinaison des données sources (1002) et des premières données CRC (1004), où la structure de données en sortie (1102) des deuxièmes données combinées comprend au moins une grappe (1104A, 1104B) de positions binaires non gelées pour une partie des données sources (1002), les premières données CRC (1004) correspondant à la partie des données sources (1002), et des deuxièmes données CRC (1008) qui codent la partie des données sources (1002) et les premières données CRC (1004) correspondant à la partie des données sources (1002),
le décodage (2404) des données en entrée reçues par le décodage de listes d'annulation successives, SCL, avec une taille de liste L, où le décodage comprend l'utilisation d'une pluralité d'étapes de décodage successives de façon à obtenir récursivement les données sources, les premières données CRC et les deuxièmes données CRC par, à chaque étape :
la génération (2406) d'exactement deux trajets de décodage dupliqués pour chaque trajet de L trajets de façon à fournir un ensemble de 2L trajets candidats, les deux trajets de décodage dupliqués représentant des décisions respectives de 0 et de 1, où L est un entier supérieur à 1,
l'évaluation (2408), en fonction des données sources, de l'ensemble de 2L trajets candidats de façon à déterminer un ensemble de L trajets les plus fiables à partir de l'ensemble de 2L trajets candidats,
la suppression (2410) d'une évaluation complémentaire de la totalité des trajets à l'exception de l'ensemble de L trajets les plus fiables, et
la conservation de l'ensemble de L trajets les plus fiables pour une étape de décodage suivante, l'exécution d'un premier contrôle CRC au moyen des deuxièmes données CRC (1008) pour chacun des trajets de décodage aussi précocement dans le processus de décodage que possible, comprenant
l'évaluation (2412), en fonction des deuxièmes données CRC (1008), de l'ensemble de L trajets les plus fiables de façon à déterminer un sous-ensemble de trajets passant un contrôle de parité CRC, et
la terminaison (2414) des opérations de décodage si le sous-ensemble de trajets passant le contrôle de parité CRC est vide.

6. Le procédé selon la Revendication 5, où :
le décodage des données en entrée au moyen d'une pluralité d'étapes de décodage successives comprend en outre, au lieu de l'évaluation (2412), en fonction des deuxièmes données CRC, de l'ensemble de L trajets les plus fiables et avant l'opération d'évaluation (2408) en fonction des données sources,
l'évaluation (2308), en fonction des deuxièmes données CRC et aussi précocement dans le processus de décodage que possible, de l'ensemble de 2L trajets candidats de façon à déterminer un sous-ensemble de trajets passant le contrôle de parité CRC, et
la suppression d'une évaluation complémentaire de la totalité des trajets à l'exception du sous-ensemble de trajets passant le contrôle de parité CRC, et
la conservation du sous-ensemble de trajets passant le contrôle de parité CRC pour une évaluation complémentaire.

7. Le procédé selon la Revendication 5, où la réception de données en entrée par l'intermédiaire d'un canal comprend la réception des données en entrée par l'intermédiaire d'un canal parmi d'un canal de commande en liaison descendante physique et un canal de commande en liaison montante physique.

8. Un appareil (500) de communication, comprenant :
un ensemble de circuits de réception (512) configuré de façon à recevoir des données en entrée par l'intermédiaire d'un canal, les données en entrée représentant un mot de code codé au moyen d'un code polaire sur des deuxièmes données combinées, les deuxièmes données combinées possédant une structure de données en sortie (1102) et étant une combinaison de données sources (1002), de deuxièmes données de contrôle de redondance cyclique, CRC, (1008) et de premières données CRC (1004), les premières données CRC (1004) codant les données sources (1002), les deuxièmes données CRC (1008) codant des premières données combinées qui sont une combinaison des données sources (1002) et des premières données CRC (1004),
où la structure de données en sortie (1102) des deuxièmes données combinées comprend au moins une grappe (1104A, 1104B) de positions binaires non gelées pour une partie des données sources (1002), les premières données CRC (1004) correspondant à la partie des données sources (1002), et des deuxièmes données CRC (1008) qui codent la partie des données sources (1002), et les premières données CRC (1004) correspondant à la partie des données sources (1002), et
un système de traitement comprenant un processeur (504) et une mémoire (506), le système de traitement étant configuré de façon à :
recevoir les données en entrée par l'intermédiaire d'un canal,
décoder les données en entrée reçues par le décodage de listes d'annulation successives, SCL, avec une taille de liste L, où le décodage comprend l'utilisation d'une pluralité d'étapes de décodage successives de façon à obtenir récursivement les données sources, les premières données CRC et les deuxièmes données CRC, et à chaque étape, le système de traitement est configuré de façon à :
générer exactement deux trajets de décodage dupliqués pour chaque trajet de L trajets de façon à fournir un ensemble de 2L trajets candidats, les deux trajets de décodage dupliqués représentant des décisions respectives de 0 et de 1, où L est an entier supérieur à 1,
évaluer, en fonction des données sources, l'ensemble de 2L trajets candidats de façon à déterminer un ensemble de L trajets les plus fiables à partir de l'ensemble de 2L trajets candidats,
supprimer d'une évaluation complémentaire la totalité des trajets à l'exception de l'ensemble de L trajets les plus fiables, et
la conservation de l'ensemble de L trajets les plus fiables pour une étape de décodage suivante,
exécuter un premier contrôle CRC au moyen des deuxièmes données CRC (1008) pour chacun des trajets de décodage aussi précocement dans le processus de décodage que possible,
comprenant le système de traitement qui est configuré de façon à évaluer, en fonction des deuxièmes données CRC (1008), l'ensemble de L trajets les plus fiables de façon à déterminer un sous-ensemble de trajets passant un contrôle de parité CRC et
terminer les opérations de décodage si le sous-ensemble de trajets passant le contrôle de parité CRC est vide.
